# FASCICULE DE BREVET EUROPEEN

(11) **EP 3 455 297 B1**
(45) Date de publication et mention de la délivrance du brevet: **24.07.2024**
(21) Numéro de dépôt: 17720812.1
(22) Date de dépôt: 03.05.2017
(51) Int. Cl.: C09B 23/01, H01G 9/20, H01L 31/0224, C09B 23/10, C09B 57/00, H10K 85/60

(54) **COLORANT ORGANIQUE À EFFICACITÉ AMÉLIORÉE ET SES UTILISATIONS DANS LES CELLULES PHOTOVOLTAÏQUES**
ORGANISCHER FARBSTOFF MIT VERBESSERTER EFFIZIENZ UND VERWENDUNGEN DAVON IN FOTOVOLTAISCHEN ZELLEN
ORGANIC DYE WITH IMPROVED EFFICIENCY AND USES THEREOF IN PHOTOVOLTAIC CELLS

(30) Priorité: 09.05.2016 FR 1654125
(43) Date de publication de la demande: 20.03.2019
(73) Titulaire: Commissariat à l'Energie Atomique et aux Energies Alternatives, 75015 Paris (FR)
(72) Inventeur: DEMADRILLE, Renaud, 38120 SAINT-EGREVE (FR); KERVELLA, Yann, 38160 SAINT-VERAND (FR); JOLY, Damien, 38360 SASSENAGE (FR); GODFROY, Maxime, 38250 LANS-EN-VERVORS (FR)
(74) Mandataire: Brevalex
(86) Numéro de dépôt international: PCT/EP2017/060528
(87) Numéro de publication internationale: WO 2017/194368

(56) Documents cités:
- WO-A1-2013/068588
- US-A1- 2007 073 052

## Description

### DOMAINE TECHNIQUE

La présente invention appartient au domaine de l'énergie photo-électrique et, notamment, au domaine des cellules et dispositifs photovoltaïques.

Plus particulièrement, la présente invention propose une famille de composés purement organiques, basés sur des chromophores pi-conjugués et leur utilisation comme photo-sensibilisateurs d'électrode dans des dispositifs photovoltaïques.

Les composés de la présente invention présentent des spectres d'absorption étendus dans le domaine visible et des coefficients d'absorption molaires élevés. En conséquence, les efficacités de conversion photovoltaïque sont élevées et ce, dans les différentes configurations de cellules solaires (électrolyte liquide, liquide ionique et électrolyte solide) étudiées. De plus, les composés de la présente invention notamment grâce à leur fonctionnalisation judicieuse permettent d'obtenir des dispositifs avec des stabilités élevées se situant parmi les plus élevées de l'état de l'art.

### ÉTAT DE LA TECHNIQUE ANTÉRIEURE

Actuellement les meilleures cellules solaires hybrides sont fabriquées à partir d'un semi-conducteur massif nanostructuré qui est généralement un oxyde de titane (TiO₂) transparent. La surface de cet oxyde est fonctionnalisée par greffage de colorants photosensibles très souvent organométalliques. Un électrolyte généralement liquide, mais qui peut être également un gel ou un solide semi-conducteur de type p, vient compléter le système, emprisonné entre deux électrodes transparentes. Ce type de cellule permet la fabrication de panneaux semi-transparents de couleurs variées en fonction du colorant choisi.

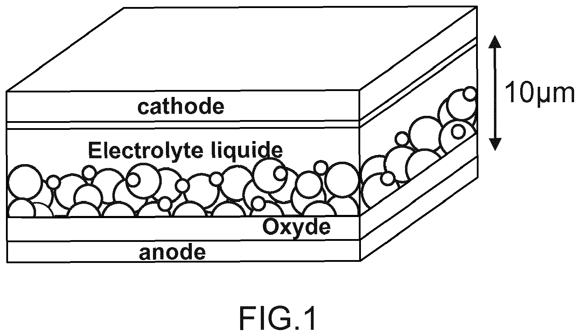

Dans ce type de cellules, les photons solaires sont absorbés par les colorants et les charges électroniques photo-générées sont ensuite injectées à partir de ces colorants dans l'oxyde dont la fonction est d'acheminer les électrons vers l'électrode. La Figure 1 est une schématisation des différents constituants d'une telle cellule photovoltaïque **[1].**

En résumé, dans ces cellules, la séparation des charges photo-générées dans le colorant intervient à l'interface entre le colorant, le semi-conducteur et l'électrolyte ce qui fait du colorant un des éléments essentiels du dispositif.

Les colorants les plus utilisés dans ce domaine jusqu'à la fin des années 2000 sont des complexes organométalliques généralement à base de ruthénium et les rendements de conversion sont compris entre 11 et 12% **[2].** Le principal désavantage des cellules hybrides, qui comptent parmi les plus efficaces dans le domaine des cellules alternatives aux technologies dites classiques, réside dans le fait qu'un colorant organométallique à base de ruthénium est extrêmement coûteux et potentiellement toxique. Le ruthénium fait partie des 9 métaux les plus rares sur terre entraînant de fait un prix de cette matière première extrêmement volatile. Enfin, le ruthénium est un élément toxique et certains de ses dérivés sont identifiés comme cancérigènes ou mutagènes.

Ainsi, le remplacement des complexes de ruthénium dans les cellules solaires par des composés organiques peu coûteux et moins toxiques dont les propriétés optoélectroniques peuvent être modulées facilement est donc souhaitable pour permettre aux cellules solaires sensibilisées à colorants de se développer à large échelle.

Récemment des colorants se présentant sous forme de molécules purement organiques ont été développés et employés de manière efficace (entre 8 et 10%) dans des cellules photovoltaïques **[3].**

De manière générale, ces sensibilisateurs doivent impérativement posséder des niveaux énergétiques dont les positions sont bien ajustées au potentiel d'oxydo-réduction (ou redox) de l'électrolyte et au niveau de la bande de conduction de l'oxyde. Mais un point crucial concerne les propriétés d'absorption des molécules qui doivent être capables d'absorber, de manière intense et sur une large gamme de longueurs d'ondes, les photons émis par le soleil. De plus, la fonction d'ancrage que ce dernier doit comporter pour se fixer de manière stable à la surface de l'oxyde est également importante : elle doit être adaptée à la surface de l'oxyde.

La plupart des composés organiques employés sont conçus et construits selon le schéma suivant :

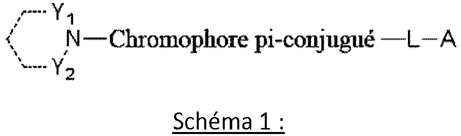

### Principe de conception des colorants organiques

Ils présentent donc :
- un segment électro-donneur (eD) à propriétés redox stables i.e. une fonction redox de type arylamine (-N(Y₁)(Y₂)) qui permet au colorant d'être réduit plus facilement par l'électrolyte ;
- une partie pi-conjuguée, plus au moins étendue, qui permet d'absorber efficacement les photons solaires et qui permet aux charges d'être évacuées dans l'oxyde plus facilement ;
- et enfin une fonction d'ancrage à caractère électro-accepteur (A) de type carboxylique ou cyano-acrylique qui est reliée au système pi-conjugué de la molécule par un espaceur (L) comportant, de préférence, une fonction éthylénique.

Cette fonction d'ancrage permet le greffage et la sensibilisation des particules en facilitant le transfert électronique des noyaux aromatiques électro-déficients vers l'oxyde. Il faut toutefois noter que la fonction d'ancrage de type carboxylique est particulièrement bien adaptée pour le greffage sur TiOz mais moins pour le ZnO. En effet, des risques d'attaque chimique du ZnO et de dégradation de la couche sont à craindre si on utilise un groupe carboxylique **[4,5]**.

Les règles de conception de ces colorants sont exposées dans la revue d'Ooyama et Harima **[6]**. Sur la base de ces règles, de nombreux colorants ont récemment été conçus et/ou publiés ou brevetés dans le domaine des cellules photovoltaïques mais certaines limitations existent avec les colorants actuels.

Afin d'augmenter les performances des colorants en dispositifs, il apparaît crucial d'améliorer leurs propriétés d'absorption, c'est-à-dire d'augmenter la gamme spectrale d'absorption des photons, idéalement dans la partie visible du spectre solaire, et d'augmenter les coefficients d'absorption molaire des molécules. En résumé les molécules de colorant doivent absorber de manière intense et sur une gamme large les photons solaires. Un autre point apparaît crucial : améliorer la stabilité des colorants en basant leur conception sur des motifs pi-conjugués robustes.

La stratégie visant à augmenter les coefficients d'absorption des colorants a été employée, pour la première fois, en 2005, avec des complexes de ruthénium. En modifiant les ligands hétéroleptiques, c'est-à-dire en introduisant des unités vinylènes ou des chromophores qui servent d'antennes sur ces derniers, une augmentation de leurs coefficients d'absorption a été observée **[7]**. Il en résulte une amélioration des propriétés photovoltaïques du système.

De nombreux travaux existent pour tenter d'améliorer les coefficients d'absorption molaire des composés à base de ruthénium. Toutefois, de manière surprenante, il n'existe aucun travail visant à spécifiquement améliorer les coefficients d'absorption molaire des colorants organiques existants ou encore à améliorer leurs stabilités.

Ainsi, les coefficients d'absorption molaire des colorants purement organiques actuellement utilisés sont encore faibles. C'est par exemple le cas des colorants décrits dans la demande internationale WO 2009/109499 **[8]** dont les coefficients d'absorption molaire sont tous inférieurs à 48000 M⁻¹.cm⁻¹ et les rendements de conversion sont tous inférieurs à 5,1%, lorsque les cellules sont fabriquées avec un électrolyte liquide et un co-adsorbant de type acide chenodéoxycholique dont la structure est reprise ci-après :

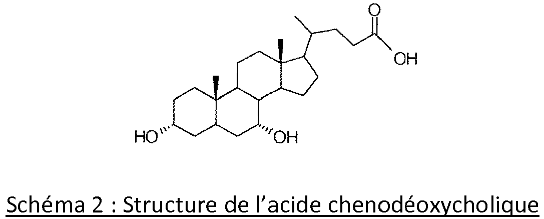

D'autres exemples sont rapportés dans la littérature **[9-12].** Toutefois, le même problème est rencontré avec des coefficients d'absorption molaire qui sont inférieurs à 40000 M⁻¹.cm⁻¹ et les efficacités en cellules fabriquées avec une électrode de TiO₂ et un électrolyte liquide qui sont inférieures à 4,5%.

En 2008, un article a rapporté l'emploi de colorant à base de EDOT (3,4-éthylèndioxythiophène) présentant des spectres largement décalés dans le visible et, malgré, là encore, des coefficients d'absorption molaire faibles, des rendements assez élevés (de l'ordre de 7%) ont été obtenus **[13].**

A l'heure actuelle les colorants les plus efficaces sont des colorants qui comportent des motifs porphyrines **[14].** Les performances atteignent avec ces composés des valeurs de 12 à 13% en rendement de conversion avec un électrolyte liquide à base de cobalt. Cependant ces efficacités record ne sont pas accompagnées de bonnes stabilités. En effet, les cellules à base de porphyrines ne sont pas stables et il est rare de voir dans la littérature des estimations de la durée de vie des dispositifs les contenant, la stabilité de ces cellules solaires ne dépassant pas 1000 h. En effet les pertes d'efficacité sont souvent de plus de 25% de l'efficacité initiale après cette période d'irradiation.

Depuis 2012, ont été décrites de nouvelles familles de colorants organiques dont les performances atteignent 10,2% de rendement avec électrolyte liquide et 7,4% avec liquide ionique, ces familles présentant des stabilités remarquables. Certains de ces colorants figurent parmi les plus stables jamais rapportés dans la littérature **[15-17].**

Les inventeurs se sont fixé pour but de proposer de nouveaux colorants organiques qui présentent des propriétés optiques améliorées à la fois en termes de décalage dans le domaine visible du spectre solaire correspondant à la gamme spectrale comprise entre 400 et 800 nm mais également en termes de coefficient d'absorption molaire et ce, afin d'améliorer à la fois les propriétés d'efficacité et de stabilité des dispositifs photovoltaïques les contenant.

### EXPOSÉ DE L'INVENTION

La présente invention permet de résoudre tout ou partie des problèmes techniques listés ci-dessus et, notamment, les problèmes de stabilité et d'efficacité des cellules solaires.

En effet, les travaux des inventeurs ont permis de synthétiser de nouveaux colorants organiques et, plus particulièrement, des chromophores pi-conjugués compris dans ces derniers, présentant des associations de groupements fonctionnels particuliers tels que des 4H-indeno[1,2-b]thiophènes avec des benzothiadiazoles, des thiophènes, des phényles et des furanes. De tels colorants utilisés comme photo-sensibilisateurs dans des dispositifs photovoltaïques à base d'oxyde métallique permettent (i) de décaler dans la partie visible du spectre solaire la bande d'absorption maximale (λmax), (ii) d'augmenter de manière significative le coefficient d'absorption molaire et (iii) d'améliorer les rendements de conversion photovoltaïque (iv) et d'améliorer la stabilité des dispositifs qui les emploient.

Ainsi, la présente invention concerne un colorant organique répondant à l'une des structures (I) ou (II) suivantes :
eD -chromophore pi-conjugué - L-A (I)
A-L-chromophore pi-conjugué-eD (II)
avec
- eD représente un segment électro-donneur,
- L représente une liaison covalente ou un segment espaceur et notamment un segment espaceur pi-conjugué,
- A représente un segment électro-attracteur apte à former une liaison covalente avec un semi-conducteur,
dans lequel le chromophore pi-conjugué comprend au moins un motif de formule (III) : 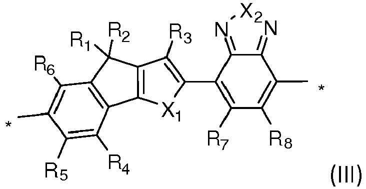 dans laquelle
- les radicaux R₁ et R₂, identiques ou différents, représentent un groupement aryle éventuellement substitué ;
- les radicaux R₃ à R₈, identiques ou différents, représentent un hydrogène, un groupement alkyle éventuellement substitué ou un groupement aryle éventuellement substitué ; et
- X₁ et X₂, identiques ou différents sont choisis parmi S, Se et O.

Dans le motif (III) présent dans le chromophore pi-conjugué du colorant selon la présente invention, les radicaux R₁ et R₂ sont obligatoirement des groupes aromatiques. En effet, les travaux des inventeurs ont découvert que la stabilité de tels colorants est améliorée en utilisant des motifs aryles éventuellement substitués à la place des groupements alkyles des composés connus dans l'art antérieur.

Ainsi, une modification judicieuse dans la structure des colorants récemment inventés et mentionnés dans les documents **[15-17]** conduit à la nouvelle famille de colorants selon l'invention qui présentent des propriétés optiques améliorées, à la fois, en termes de décalage spectral dans le domaine visible mais également en termes de coefficient d'absorption molaire. Les colorants basés sur des motifs 4,4'-bis(aryl)-4H-indéno[1,2-b]thiophène substitués judicieusement sur la position 4 et combinés à une unité benzothiadiazole en position alpha du thiophène permettent d'améliorer à la fois les propriétés d'efficacité et la stabilité des dispositifs les contenant. L'effet bénéfique de cette simple modification par rapport à la structure de RK1 et RKF publiée dans **[17]** ne pouvait pas être anticipé sur la base de résultats préexistants. Cette amélioration des propriétés est également attendue lorsque l'un ou les deux atomes de soufre dans ces colorants est/sont remplacé(s) par un atome d'oxygène ou de sélénium.

De plus, les colorants organiques selon la présente invention sont synthétisés de façon beaucoup plus simple et ce, grâce à cette modification de structure. En effet, la synthèse de dérivés de la famille RKF connue de la littérature nécessite 9 étapes et donne un rendement global de 10% environ. Lorsque les substituants alkyles de RKF sont remplacés par des substituants aryles éventuellement substitués tels que des phényles substitués pour donner un composé selon l'invention, le nombre d'étapes est réduit à 6 et le rendement global de la synthèse est de l'ordre de 26%.

Avantageusement, le colorant organique selon la présente invention répond à la structure (I) telle que précédemment définie.

Par « groupement alkyle », on entend, dans le cadre de la présente invention, un groupement alkyle, linéaire ou ramifié, cyclique comprenant de 1 à 20 atomes de carbone, notamment de 1 à 15 atomes de carbone et en particulier, de 1 à 10 atomes de carbone, pouvant comporter éventuellement au moins un hétéroatome, comme, par exemple, un groupe méthyle, éthyle, n-propyle, isopropyle, butyle, isobutyle, sec-butyle, tert-butyle, pentyle, isopentyle, hexyle, heptyle, octyle, nonyle ou décyle.

Par « groupement aryle », on entend, dans le cadre de la présente invention, un groupement aryle à un cycle ou plusieurs cycles fusionnés ou reliés par une liaison unique ou par un groupe hydrocarboné, chaque cycle ayant de 4 à 20 atomes de carbone, notamment de 4 à 14 atomes de carbone, en particulier, de 4 à 8 atomes de carbone et pouvant comporter éventuellement au moins un hétéroatome. A titre d'exemples de groupe aryle, on peut citer les groupes phényle, biphényle, naphtyle, anthracényle, cyclopentadiényle, pyrényle, tétrahydronaphtyle, furanyle, pyrrolyle, thiophényle, oxazolyle, pyrazolyle, isoquinolinyle, thiazolyle, imidazolyle, triazolyle, pyridinyle, pyranyle, quinolinyle, pyrazinyle et pyrimidinyle.

Par « groupement alkyle substitué » ou « groupement aryle substitué », on entend, dans le cadre de la présente invention, un groupement alkyle ou aryle tel que précédemment défini substitué par un groupement ou plusieurs groupements identiques ou différents choisi(s) parmi un halogène ; une amine ; une diamine ; un carboxyle ; un carboxylate ; un aldéhyde ; un ester; un éther; un hydroxyle ; un halogène ; un aryle éventuellement substitué tel que précédemment défini et notamment tel qu'un phényle, un benzyle ou un naphthyle ; un alkyle éventuellement substitué tel que précédemment défini et notamment tel qu'un méthyle, un éthyle, un propyle, un butyle, un pentyle, un hexyle ou un hydroxypropyle ; un amide ; un sulfonyle ; un sulfoxyde ; un acide sulfonique ; un sulfonate ; un acyle ; un vinyle ; un hydroxyle un époxy; un phosphonate ; un isocyanate ; un thiol ; un glycidoxy; un acryloxy; un thiophène ; un furane ; un sélénophène et leurs sels.

Il est évident que les groupements aryles éventuellement substitués mis en oeuvre dans la présente invention couvrent également des chromophores pi-conjugués et notamment des chromophores pi-conjugués tels que décrits dans la présente invention.

Par « hétéroatome », on entend, dans le cadre de la présente invention, un atome choisi dans le groupe constitué par azote, oxygène, phosphore, soufre, silicium, fluor, chlore et brome.

Par « halogène », on entend, dans le cadre de la présente invention, un atome choisi dans le groupe constitué par fluor, chlore, iode et brome.

Dans les motifs (III) selon la présente invention, le couple (X₁,X₂) représente (S,S), (O,O), (Se,Se), (O,Se), (Se,O), (S,O), (O,S), (Se,S) ou (S,Se). Avantageusement, le couple (X₁,X₂) représente (S,S), (O,O) ou (Se,Se) et, en particulier, (S,S).

Parmi les motifs (III), des motifs avantageux sont ceux dans lesquels les radicaux R₄ à R₆ sont identiques et/ou les radicaux R₇ et R₈ sont identiques et notamment ceux dans lesquels les radicaux R₄ à R₆ représentent tous un hydrogène et/ou les radicaux R₇ et R₈ représentent tous un hydrogène. Dans ces motifs avantageux, le radical R₃ représente typiquement un hydrogène.

Dans ces motifs (III) avantageux, les radicaux R₁ et R₂ sont identiques et représentent un groupement aryle éventuellement substitué tel que précédemment défini.

Dans un mode de réalisation particulier, les radicaux R₁ et R₂ sont identiques et représentent un groupement aryle substitué tel que précédemment défini. Plus particulièrement, ce groupement aryle substitué est un groupement aryle substitué par un groupement alkyle éventuellement substitué tel que précédemment défini. Plus particulièrement encore, ce groupement aryle substitué est un groupement aryle substitué par un groupement méthyle, éthyle, n-propyle, isopropyle, butyle, isobutyle, sec-butyle, tert-butyle, pentyle, isopentyle, hexyle, heptyle ou un octyle.

Un motif (III) particulièrement intéressant dans le cadre de la présente invention est de formule (IV) : 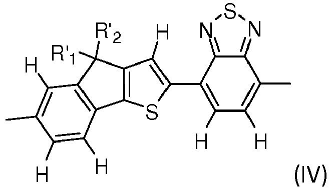 dans laquelle les radicaux R'₁ et R'₂ sont identiques et représentent -C₆H₄-C₆H₁₃.

Le colorant organique selon la présente invention comprend au moins un chromophore pi-conjugué tel que défini dans la présente invention. Il peut en comprendre au moins deux, identiques ou différents ou au moins trois, identiques ou différents. Lorsque le colorant organique selon la présente invention comprend 2, 3 ou plus chromophores pi-conjugués, au moins un de ces chromophores est tel que défini dans la présente invention, chacun des autres pouvant être un quelconque chromophore pi-conjugué connu de l'homme du métier ou, au contraire, un chromophore tel que défini dans la présente invention.

Dans le colorant organique selon la présente invention, le chromophore pi-conjugué peut n'être constitué que par un motif ou plusieurs motifs, identiques ou différents, tels que précédemment exposés.

En variante, le chromophore pi-conjugué peut comprendre, en plus d'un motif ou de plusieurs motifs, identiques ou différents, tels que précédemment exposés, un 1^{er} groupement pi-conjugué le ou les séparant du segment électro-donneur (eD) et/ou un 2^{nd} groupement pi-conjugué, identique ou différent au 1^{er}, le ou les séparant du segment électroattracteur (A) ou du segment espaceur (L).

Dans le cadre de la présente invention, on entend par « groupement pi-conjugué » un groupement choisi parmi les chaînes alcénylène ou alcynylène éventuellement substituées, les chaînes arylène éventuellement substituées et leur combinaison.

Dans le cadre de la présente invention, on entend par « chaîne alcénylène ou alcynylène », une chaîne alcénylène ou alcynylène, linéaire, ramifiée ou cyclique, comprenant de 4 à 40 atomes de carbone et notamment de 4 à 30 atomes de carbone et pouvant comporter éventuellement au moins un hétéroatome. A titre d'exemples de chaînes alcénylène ou alcynylène utilisables, on peut citer un groupe buténylène ou butynylène, isobuténylène ou isobutynylène, *sec*-buténylène ou *sec*-butynylène, *tert-*buténylène ou *tert*-butynylène, penténylène ou pentynylène, isopenténylène ou isopentynylène, cyclopenténylène ou cyclopentynylène, cyclohexénylène ou cyclohexynylène.

Dans le cadre de la présente invention, on entend par « chaîne arylène », une chaîne arylène à un cycle ou plusieurs cycles fusionnés ou reliés par une liaison unique ou par un groupe hydrocarboné, chaque cycle ayant de 4 à 50 atomes de carbone et notamment de 4 à 40 atomes de carbone et pouvant comporter éventuellement au moins un hétéroatome. A titre d'exemples de chaînes arylène utilisables, on peut citer les groupes phénylène, biphénylène, naphtylène, anthracénylène, cyclopentadiénylène, pyrénylène, tétrahydronaphtylène, furanylène, pyrrolylène, thiophénylène, oxazolylène, pyrazolylène, isoquinolinylène, thiazolylène, imidazolylène, triazolylène, pyridinylène, pyranylène, quinolinylène, pyrazinylène et pyrimidinylène.

Dans le cadre de la présente invention, on entend par « chaîne alcénylène ou alcynylène substituée » ou par « chaîne arylène substituée », une chaîne alcénylène ou alcynylène ou une chaîne arylène telle que précédemment définie présentant une substitution ou plusieurs substitutions, identiques ou différentes, cette ou ces substitutions correspondant, de préférence, à des atomes d'halogène ou à des groupes aliphatiques comprenant éventuellement au moins un hétéroatome comme, par exemple, un groupe - COOR", -CHO, -OR", -SR", -SCOR", -SO₂R", -NR"R‴, -CONR"R‴, -C(Hal)₃, -OC(Hal)₃, -C(O)Hal ou -CN dans lesquels R" et R‴ représentent un atome d'hydrogène ou un groupement hydrocarboné tel que précédemment défini, tandis que Hal représente un atome d'halogène, notamment de fluor, de chlore ou de brome.

Par « segment électro-donneur (eD) » on entend, dans le cadre de la présente invention, une fonction électro-donneur qui permet au colorant organique selon la présente invention d'être réduit plus facilement par l'électrolyte.

L'homme du métier connaît des segments électro-donneurs habituellement utilisés dans le domaine des colorants organiques photo-sensibilisateurs. A titre d'exemples de tels segments électro-donneurs, on peut citer ceux décrits de la page 42, ligne 10 à la page 45, ligne 1 de la demande internationale WO 2009/109499 **[8]** et ceux mis en oeuvre dans les 56 colorants organiques décrits dans Mishra *et al,* 2009 **[3]**.

Le segment électro-donneur mis en oeuvre dans le cadre de la présente invention est un groupement amino de type (Z₁)(Z₂)N-, avec Z₁ et Z₂, identiques ou différents, représentant un groupement alkyle éventuellement substitué ou un groupement aryle éventuellement substitué tel que précédemment défini. En particulier, lorsque Z₁ et/ou Z₂, identiques ou différents, représentent un groupement aryle substitué, ce dernier est substitué par un groupement ou plusieurs groupements, identiques ou différents, à caractère électro-donneur. Par « groupement à caractère électro-donneur », on entend, dans le cadre de la présente invention, un groupement choisi parmi un groupement alkyle, comprenant de 1 à 10 atomes de carbone, éventuellement substitué ; un groupement alcoxy comprenant de 1 à 10 atomes de carbone, éventuellement substitué ; un groupement diamine et notamment un groupement di(alkyl)amino éventuellement substitué sur le (ou les) groupement(s) alkyle par un hydroxy ; un groupement alkylthio et un groupement thioéther.

Dans la partie expérimentale ci-après, trois exemples de segment électro-donneur sont donnés, ces derniers étant utilisables dans tout colorant organique selon l'invention. Dans ces exemples, -Z₁ = -Z₂ = -C₆H₅ (YKP88 et DJ214) ou -C₆H₄-O-CH₃ (YKP89) ou encore -C₆H₄-O-C₆H₁₃ (YKP137).

Par « segment électro-accepteur (A) » on entend, dans le cadre de la présente invention, une fonction électro-accepteur qui assure l'ancrage du colorant organique selon la présente invention sur le support solide tel qu'un support solide de type oxyde métallique tout en assurant un bon transfert de charges entre ledit support et ledit colorant.

L'homme du métier connaît des segments électro-accepteurs habituellement utilisés dans le domaine des colorants organiques photo-sensibilisateurs. A titre d'exemples de tels segments électro-accepteurs, on peut citer ceux tels que définis page 1, lignes 26 et 27 et notamment exemplifiés page 29, lignes 7 à 23 ; page 37, lignes 6 à 9 ; de la page 46, ligne 6 à la page 47, ligne 1 ou de la page 47, lignes 2 à 8 de la demande internationale WO 2009/109499 **[8]** et ceux mis en oeuvre dans les 56 colorants organiques décrits dans Mishra et *al,* 2009 **[3].**

Le segment électro-accepteur mis en oeuvre dans le cadre de la présente invention est un groupement acide carboxylique, un groupement acide cyanoacrylique, un groupement phosphonique, un groupement dithiocarboïque ou un groupement répondant à l'une quelconque des formules ci-après :

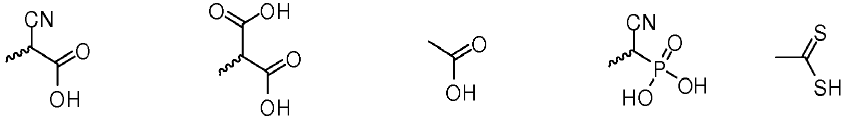

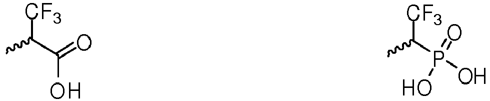

Dans le cadre de la présente invention, le chromophore pi-conjugué et le segment électro-accepteur sont avantageusement séparés l'un de l'autre par un espaceur (L).

Tout espaceur connu de l'homme du métier et habituellement utilisé dans le domaine des colorants organiques photo-sensibilisateurs est utilisable dans le cadre de la présente invention. A titre d'exemples de tels espaceurs, on peut citer ceux mis en oeuvre dans les 56 colorants organiques décrits dans Mishra *et al,* 2009 **[3].**

Dans le cadre de la présente invention, l'espaceur L est notamment une fonction pi-conjuguée comme une chaîne alcénylène ou alcynylène éventuellement substituée et/ou une chaîne arylène éventuellement substituée telle que précédemment définie. A titre d'espaceurs plus particuliers susceptibles d'être mis en oeuvre dans le cadre de la présente invention, on peut citer une chaîne éthylényle, propylényle, butényle, phénylène, benzylène, naphtylène, furanylène et l'une quelconque de leurs combinaisons.

De façon avantageuse, lorsque l'espaceur L mis en oeuvre dans le cadre de la présente invention comprend une double liaison, cette dernière est séparée du cycle benzothiadiazole (ou benzoxadiazole ou benzosélénadiazole) que contient le chromophore pi-conjugué à proximité de l'espaceur par au moins une chaîne arylène éventuellement substituée telle que précédemment définie et notamment par au moins un thiophénylène éventuellement substitué, au moins un phénylène éventuellement substitué ce qui est le cas dans les colorants YKP88 et YKP137 exemplifiés ci-après ou au moins un furanylène éventuellement substitué ce qui est le cas dans les colorants YKP89 et DJ214 exemplifiés ci-après.

De façon particulièrement avantageuse, le colorant organique selon la présente invention est choisi parmi les composés suivants :

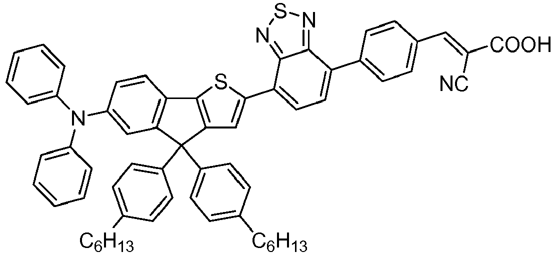

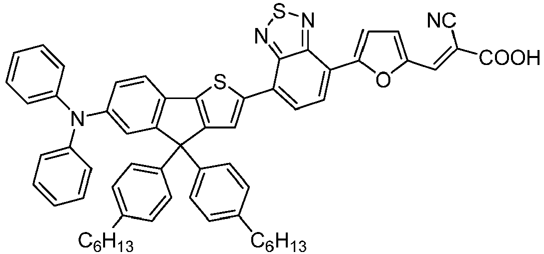

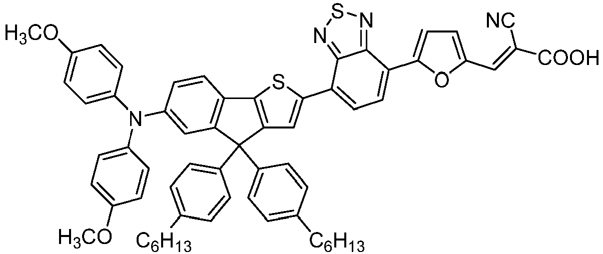

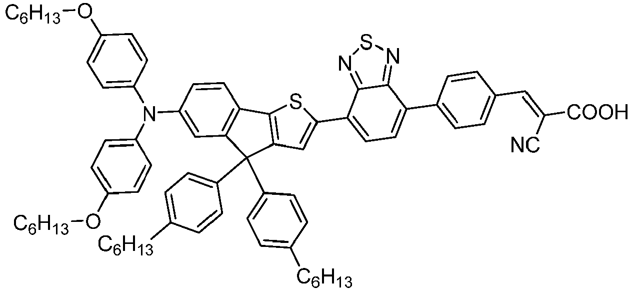

Pour tous les motifs et structures décrits dans la présente invention, cette dernière couvre l'ensemble des stéréo-isomères, l'ensemble des tautomères et l'ensemble des énantiomères envisageables.

La présente invention concerne également un procédé de préparation d'un colorant organique tel que défini dans la présente invention. Ce procédé de préparation met en oeuvre des réactions chimiques bien connues de l'homme du métier. Ce dernier, sur la base des différents protocoles explicités dans la partie expérimentale ci-après et des protocoles de préparation des colorants organiques de l'état de la technique, pourra préparer tout colorant organique selon la présente invention sans aucun effort inventif.

La présente invention concerne en outre un colorant organique tel que précédemment défini utilisé comme photo-sensibilisateur dans un dispositif photovoltaïque.

Dans le cadre de la présente invention, les expressions « dispositif photovoltaïque » et « cellule photovoltaïque » sont similaires et utilisables de façon interchangeable.

De fait, la présente invention concerne le dispositif photovoltaïque ainsi obtenu i.e. un dispositif photovoltaïque présentant une couche d'oxyde métallique semi-conducteur nanostructuré sensibilisée par au moins un colorant organique tel que défini dans la présente invention.

En d'autres termes, le colorant organique tel précédemment défini a réagi avec la couche d'oxyde métallique via son segment électro-attracteur pour donner un groupement dérivé du colorant organique fonctionnalisant, i.e. covalemment lié à, la couche d'oxyde métallique. Ces groupements fonctionnalisants présentent donc un segment électro-donneur (eD), un chromophore pi-conjugué, éventuellement un espaceur (L) et un groupement dérivé du segment électro-accepteur (A) covalemment lié à la couche d'oxyde métallique, le segment électro-donneur (eD), le chromophore pi-conjugué, l'espaceur (L) et le segment électro-accepteur (A) étant tels que précédemment définis.

Dans le cadre de la présente invention, lorsque le colorant organique réagit avec, i.e. est adsorbé sur, la couche d'oxyde métallique, cette réaction peut avoir lieu en présence d'un additif tel qu'un autre colorant organique ou un co-adsorbant.

L'autre colorant organique qui peut être également adsorbé sur la couche d'oxyde métallique peut être (a) un autre colorant selon la présente invention, (b) un mélange de colorants selon la présente invention, (c) un autre colorant différent d'un colorant selon la présente invention et (d) un mélange comprenant au moins un autre colorant selon la présente invention et au moins un autre colorant différent d'un colorant selon la présente invention. La partie expérimentale ci-après décrit les résultats obtenus en utilisant plusieurs colorants organiques selon l'invention et un colorant organique selon l'invention associé à un autre colorant organique différent d'un colorant selon l'invention (Tableaux 2 et 3).

Par « colorant différent d'un colorant selon la présente invention », on entend, dans le cadre la présente invention, un colorant choisi parmi un colorant complexe métallique et/ou un colorant organique tel qu'un colorant de type indoline, courmarine, cyanine, merocyanine, hemicyanine, methine, azo, quinone, quinonimine, dicéto-pyrrolo-pyrrole, quinacridone, squaraine, triphénylméthane, pérylène, indigo, xanthène, éosin, rhodamine, phtalocyanine éventuellement métallée, porphyrine éventuellement métallée et leurs mélanges. Un colorant différent d'un colorant selon la présente invention peut également être l'un quelconque des colorants organiques décrits dans **[15-17].**

A titre de co-adsorbants utilisables dans le cadre de la présente invention, on peut citer les co-adsorbants stéroïdes tels que l'acide déoxycholique, l'acide déhydrodéoxycholique, l'acide chénodéoxycholique, l'ester méthylique d'acide cholique, le sel sodique d'acide cholique ou un de leurs mélanges.

Le dispositif photovoltaïque selon la présente invention comprend en outre deux électrodes, dénommées, dans le cadre de l'invention, anode et contre électrode, et séparées l'une de l'autre par un électrolyte et éventuellement des cales polymères.

Avantageusement, l'anode mise en oeuvre dans le cadre de la présente invention est constituée d'une couche d'un oxyde conducteur transparent, comme une couche de dioxyde d'étain dopé au fluor (SnOz:F ou FTO) ou d'oxyde d'étain et d'indium (ITO), déposée sur une plaque de verre.

Dans le cadre de la présente invention, on entend par « oxyde métallique semi-conducteur » tout oxyde métallique binaire, tertiaire ou quaternaire. Dans le cadre de la présente invention, on entend par « oxyde métallique semi-conducteur nanostructuré » tout oxyde métallique semi-conducteur tel que précédemment défini comprenant des pores et notamment des pores dont la taille moyenne est comprise entre 20 et 500 Å i.e. tout oxyde métallique semi-conducteur tel que précédemment défini mésoporeux. Ainsi, la couche d'oxyde métallique semi-conducteur nanostructuré sous forme d'une couche mésoporeuse est déposée sur l'anode telle que précédemment définie.

Dans le cadre de la présente invention, on entend, par « oxyde métallique binaire », un oxyde métallique de type M^{II}O, M^{III}₂O₃ ou M^{V}₂O₅ avec M représentant un métal mono-, bi -, tri-, pentavalent et O l'atome d'oxygène. A titre d'exemples de tels oxydes métalliques binaires, on peut citer TiO₂, ZnO, SnO₂, NbzOs, In₂O₃ et RuO₂.

Dans le cadre de la présente invention, on entend, par « oxyde métallique tertiaire », un oxyde métallique multi-cations de type MM'O avec M et M' représentant deux métaux bivalents différents. A titre indicatif, on peut citer Zn₂SnO₄, SrTiO₄, SrTiOs, BaSnO₃.

Dans le cadre de la présente invention, on entend, par « oxyde métallique quaternaire », une composition d'oxydes mixtes. Dans le cadre de la présente invention, on entend, par « composition d'oxydes mixtes » :
- un mélange de deux oxydes binaires tels que précédemment définis. On peut citer par exemple des mélanges tels que (ZnO)₁₋ₓ-(SnO₂)ₓ, (TiO₂)₁₋ₓ-(Nb₂O₅)ₓ, ou
- un mélange d'un oxyde binaire et d'un oxyde tertiaire tels que précédemment définis. On peut citer par exemple un mélange de (SnO₂)-(SrTiO₃).

Dans le cadre du dispositif photovoltaïque selon la présente invention, l'électrolyte peut être un liquide, un liquide ionique, un gel ou un solide. Un tel électrolyte est notamment tel que présenté dans le livre de Kalyanasundaram K., 2010 **[18].**

Lorsque l'électrolyte est un électrolyte liquide, il est avantageusement choisi parmi les électrolytes liquides habituels tels que I⁻/I₃⁻, Br⁻/Br₂, SCN⁻/(SCN)₂ ou des complexes de cobalt de type Co(III/II).

Lorsque l'électrolyte est un électrolyte de type gel ou liquide ionique, il est avantageusement choisi parmi les sels d'imidazolium tels que, à titre d'exemples et de manière non exhaustive, le sélénocyanate de 1-éthyl-3-méthylimidazolium (EMISeCN), le thiocyanate de 1-éthyl-3-méthylimidazolium (EMISCN) ou l'iodure de 1-méthyl-3-n-hexylimidazolium (MHlml).

Lorsque l'électrolyte est un électrolyte de type solide, il est avantageusement choisi parmi un solide semi-conducteur de type p, tel qu'un polymère ou une petite molécule, pouvant être déposé par voie liquide. Plus particulièrement, l'électrolyte de type solide susceptible d'être mis en oeuvre dans le cadre de la présente invention est choisi parmi le composé spiro-OMeTAD ou un dérivé de triarylamine. On peut utiliser également un polymère pi-conjugué comme, par exemple, du poly(3,4-éthylènedioxythiophène) (PEDOT) ou un mélange de PEDOT et de polystyrène sulfonate) de sodium (PSS) connu sous l'appellation PEDOT:PSS.) On peut également utiliser un polymère de type poly(oxyde d'éthylène) contenant un couple rédox ou encore la polyaniline.

Quel que soit le type d'électrolyte mis en oeuvre dans le cadre de la présente invention, ce dernier comprend en outre un couple redox tel que le couple redox I⁻/I₃⁻ ou un complexe de cobalt et éventuellement du 4-tert-butylpyridine (tert-BP) et/ou un anion du type bis(trifluoro-méthanesulfonyl)imide (TFSI) tel que du bis(trifluoro-méthanesulfonyl)imide de lithium (Li-TFSI) et ce, notamment pour améliorer la conductivité de l'électrolyte.

Dans le cadre de la présente invention, on entend, par « cale polymère », un polymère adhésif thermique permettant de sertir les deux électrodes. De tels polymères adhésifs sont notamment les colles de chez Solaronix telles que celles de la gamme Amosil ou encore Meltonix ou encore les colles de la gamme FastelFilm de chez Dupond. Ces polymères se présentent sous la forme de feuilles thermoplastiques épaisses thermofusibles. L'étanchéité survient lorsque le polymère est chauffé à environ 100°C pendant quelques secondes, par exemple, à l'aide d'un laminateur à vide, d'une presse à chaud ou d'un fer à souder pour les petites surfaces. Typiquement, les joints ou les bandes sont découpé(e)s et disposé(e)s sur le substrat d'électrode avant une lamination à chaud.

Enfin, la contre-électrode du dispositif photovoltaïque selon la présente invention est constituée par une couche métallique comme une couche d'or ou de platine déposée sur un support solide transparent tel qu'un support en un oxyde conducteur transparent, comme un support en FTO ou en ITO selon un mode opératoire bien connu de l'homme de métier.

D'autres caractéristiques et avantages de la présente invention apparaîtront encore à l'homme du métier à la lecture des exemples ci-dessous donnés à titre illustratif et non limitatif, et faisant référence aux figures annexées.

### BRÈVE DESCRIPTION DES DESSINS

La Figure 1 est une représentation schématisée d'une cellule photovoltaïque telle que décrite dans l'article de O'Regan et Grätzel, 1991 **[1].**
La Figure 2 présente le spectre d'absorption des colorants de l'invention (YKP88, YKP89, YKP137 et DJ214) en solution dans le chloroforme, comparés aux colorants de référence RK1 et RKF, publiés dans l'article de Joly *et al,* 2015 **[17].**
La Figure 3 présente la stabilité de colorants selon la présente invention (YKP88 et YKP89) comparés à des colorants de référence (RK1 et RKF) en fonction de la durée d'irradiation à 1000 W/m² avec un filtre UV à 65°C.

### EXPOSÉ DÉTAILLÉ DE MODES DE RÉALISATION PARTICULIERS

### I. Synthèse du colorant YKP88.

### 1.1. 5-bromo-2-(thiophèn-2-yl)benzoate de méthyle [YKC4P80]

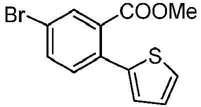

Sous atmosphère d'argon, du 5-bromo-2-iodobenzoate de méthyle (2,50 g, 7,33 mmol) et du palladium tétrakis(triphénylphosphine) (423 mg, 5% mol) sont dissous dans 30 mL de tétrahydrofurane (THF). A température ambiante, est ajouté, goutte à goutte, du bromure de 2-thiénylzinc (1,67 g, 7,33 mmol) et la solution est remuée vigoureusement et chauffée à 70°C toute une nuit. La réaction est stoppée avec une solution de HCL (2 M) et la phase organique est extraite avec du diéthyléther, lavée avec de l'eau et de la saumure, séchée sur du sulfate de sodium (Na₂SO₄), filtrée et concentrée sous vide. Le produit brut est purifié par chromatographie sur gel de silice en utilisant, comme éluant, du n-hexane/dichlorométhane (DCM) : 9:1 (v/v) puis 7/3 (v/v) moyennant quoi une huile incolore est obtenue (2,15 g, 7,24 mmol, 98,7%).

| | |
|---|---|
| *RMN ¹H (CDCl₃, 200 MHz):* | *δ* = *7,86 (dd, 1H, J*=*4,8 Hz, J*=*0,3 Hz, Hₐᵣ), 7,61 (dd, 1H, J*=*2,1 Hz, J*=*8,3 Hz, Hₐᵣ), 7,35 (m, 2H, Hₐᵣ), 7,04 (m, 2H, Hₐᵣ), 3,75 (s, 3H).* |
| *RMN ¹³C (CDCl₃, 50 MHz):* | *δ*=*167,3 ; 141,1 ; 134,2 ; 134,1 ; 133,3 ; 133,0 ; 132,5 ; 127,7 ; 127,1 ; 136,6 ; 121,9 ; 62,1 ; 14,3.* |

### I.2. 6-bromo-4,4'-bis(4-hexylphényl)-4H-indéno[1,2-b]thiophène [YKC4P81]

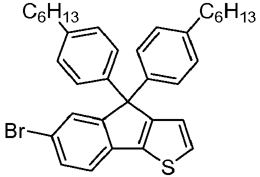

Sous atmosphère d'argon, du bromure de (4-hexylphényl)magnésium a été préalablement préparé à partir de 1(4-bromophényl)hexane (2,0 g, 8,29 mmol) et de magnésium (202 mg, 8,29 mmol, 1 eq) dans 10 mL de THF fraîchement distillé. Ce mélange réactionnel est porté à reflux pendant 1 h. Dans un second flacon, du 5-bromo-2-(thiophèn-2-yl)benzoate de méthyle [YKC4P80] (1 g, 3,37 mmol) est solubilisé dans 15 mL de THF. Ensuite le réactif de Grignard est ajouté goutte à goutte et la solution est chauffée à reflux pendant 5 h. Après refroidissement à température ambiante, le mélange brut est versé dans l'eau. La phase organique est extraite deux fois avec de l'acétate d'éthyle et lavée avec de l'eau et de la saumure, séchée sur du Na₂SO₄, filtrée et concentrée sous vide. Le produit brut est dissous dans de l'acide acétique glacial (40 mL). Après 30 min, 4 mL d'HCl concentré sont ajoutés goutte à goutte et le mélange est porté à reflux à 120°C pendant 5 h. Après retour à la température ambiante, l'acide acétique est éliminé par évaporation rotative et le produit brut est extrait par du pentane. La couche organique est lavée plusieurs fois avec de l'eau et séchée sur du Na₂SO₄, filtrée et concentrée sous vide. Le produit brut est purifié par chromatographie sur gel de silice en utilisant, comme éluant, du n-hexane moyennant quoi une huile incolore est obtenue (1,40 g, 2,45 mmol, 72,8%).

| | |
|---|---|
| *RMN ¹H (CDCl₃, 400 MHz):* | *δ*=*7,47 (d, 1H, J*=*1,7 Hz), 7,40 (dd, 1H, J*=*1,8 Hz, J*=*8,0 Hz, Hₐᵣ), 7,31 (d, 1H, J*=*4,9 Hz, Hₐᵣ), 7,30 (d, 1H, J*=*8,0 Hz, Hₐᵣ), 7,05 (ABq, 8H, Δvab*=*13,3 Hz, J*=*8,38 Hz, Hₐᵣ), 6,99 (d, 1H, J*=*4,9 Hz, Hₐᵣ), 2,54 (t, 4H), 1,57 (m, 4H), 1,29 (m, 12H), 0,87 (t, 6H).* |
| *RMN ¹³C (CDCl₃, 100 MHz):* | *δ* = *156,17 ; 155,54 ; 141,42 ; 414,00 ; 139,69 ; 136,06; 130,54 ; 129,32 ; 128,44 ; 128,16 ; 127,44 ; 122,91 ; 120,25 ; 118,94 ; 35,33 ; 31,50 ; 31,11 ; 28,91 ; 22,38 ; 13,87.* |

### I.3. 4,4-bis(4-hexylphényl)-N,N-diphényl-4H-indéno[1,2-b]thiophèn-6-amine [YKC4P84]

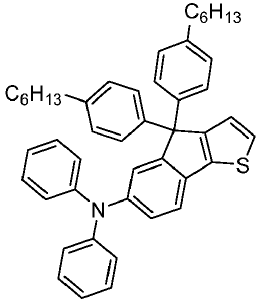

Sous atmosphère d'argon, du tris(dibenzylideneacétone) dipalladium (Pd₂dba₃) (4 mg, 4,37 µmol) et du tétrafluoroborate de tri-tert-butylphosphine (2,54 mg, 8,75 µmol) sont dissous dans du toluène anhydre (5 mL). Après agitation pendant 15 min, une solution de 6-bromo-4,4'-bis(4-hexylphényl)-4H-indéno[1,2-b]thiophène [YKC4P81] (250 mg, 437,3 µmol) et de diphénylamine (81,4 mg, 481,0 µmol) dans du toluène anhydre (10 mL) est ajoutée. Du *tert*-butoxyde de potassium (161,94 mg, 1,44 mmol, 3,3 eq) est ajouté et le mélange résultant est agité pendant 30 min à température ambiante, avant d'être porté à reflux pendant 48 h. Le mélange est ensuite filtré à travers de la célite et versé dans du HCl (2 M). La phase organique est extraite avec du DCM, séchée sur du Na₂SO₄ et concentrée. L'huile brute est purifiée par chromatographie sur gel de silice en utilisant, comme éluant, du *n*-hexane/DCM : 9:1 (v/v) moyennant quoi une huile jaune pâle est obtenue (266 mg, 403 µmol, 92,2%).

| | |
|---|---|
| *RMN ¹H (CDCl₃, 400 MHz):* | *δ*=*7,28 (d, 1H, J*=*8,2 Hz, Hₐᵣ), 7,22 (d, 1H, J*=*8,2 Hz, Hₐᵣ), 7,22 (s, 1H, Hₐᵣ), 7,18 (m, 4H, Hₐᵣ), 7,04 (m, 7H, Hₐᵣ), 6,98 (m, 7H, Hₐᵣ), 6,95 (m, 1H, Hₐᵣ), 6,93 (d, 1H, J*=*2,1 Hz, Hₐᵣ), 2,53 (t, 4H, CH₂), 1,55 (m, 4H, CH₂), 1,28 (m, 12H, CH₂), 0,87 (t, 6H, CH₃).* |
| *RMN ¹³C (CDCl₃, 100 MHz):* | *δ* = *154,99 ; 147,50 ; 145,37 ; 141,69 ; 140,98 ; 131,91 ; 128,87 ; 127,92 ; 127,53 ; 126,74 ; 123,69 ; 123,01 ; 122,95 ; 122,53 ; 119,56 ; 62,62 ; 35,31 ; 31,52 ; 31,16 ; 29,49 ; 28,89 ; 22,39 ; 13,88.* |

### I.4. 4-(7-(6-(diphénylamino)-4,4-bis(4-hexylphényl)-4H-indéno[1,2-b]thiophèn-2-yl)benzo[c][1,2,5]thiadiazol-4-yl)benzaldéhyde [YKC4P87]

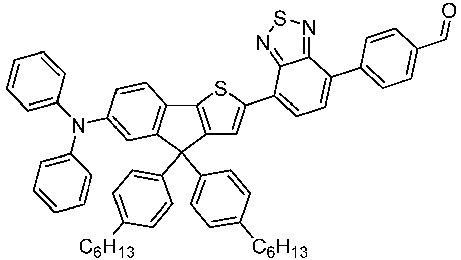

Sous atmosphère d'argon, de la 4,4-bis(4-hexylphényl)-N,N-diphényl-4H-indéno[1,2-b]thiophèn-6-amine (240 mg, 364 µmol) est dissoute dans du THF distillé (15 mL). Après avoir porté la solution à -78°C, du *n*-butyllithium (*n*-BuLi) (279 µL, 418 µmol, 1,15 eq) est ajouté. La solution est agitée pendant 1 h à -78°C avant l'ajout d'une solution de chlorure de triméthyl étain (Me₃SnCl) (545 µL, 545 µmol, 1,5 eq) dans du *n*-hexane à - 78°C. Après retour à température ambiante la solution est agitée pendant 2 h. La réaction est stoppée avec une solution saturée de chlorure d'ammonium. La phase organique est extraite avec du *n*-hexane, lavée avec de l'eau et séchée sur du Na₂SO₄, filtrée et concentrée sous vide. L'huile résultante est soumise, sans autre purification, à un couplage de Stille avec du 4-bromo-7-(4-formylbenzyl)-2,1,3-benzothiadiazole (93 mg, 291 µmol, 0,8eq). Le produit stannique est mis, sous atmosphère d'argon, avec du Pd₂dba₃ (6,66 mg, 7,27 µmol, 2%mol) et du Tri(*o*-tolyl)phosphine (P(*o*-tolyl)₃) (4,41 mg, 14,55 µmol, 4%mol). Les produits sont dissous dans du toluène anhydre (20 mL) et portés à reflux pendant 24 h. Le mélange est ensuite versé dans d'HCl (2 M). La phase organique est extraite avec du DCM, lavée avec de l'eau, séchée sur du Na₂SO₄ et concentrée. Le solide brut est purifié par chromatographie sur gel de silice en utilisant, comme éluant, du *n*-hexane/DCM : 6:4 (v/v) moyennant quoi un solide rouge sombre de type aldéhyde est obtenu (195 mg, 217 µmol, 74,6%).

| | |
|---|---|
| *RMN ¹H (CD₂Cl₂, 400 MHz):* | *δ* = *10,09 (s, 1H, CHO), 8,15 (s, 1H, Hₐᵣ), 8,10 (ABq, 4H, Δvab*=*65,6 Hz, J*=*8,3 Hz, Hₐᵣ), 7,88 (ABq, 2H, Δvab*=*60,9 Hz, J*=*7,6 Hz, Hₐᵣ), 7,42 (d, 2H, J*=*8,2 Hz, Hₐᵣ), 7,23 (m, 4H, Hₐᵣ), 7,15 (m, 5H, Hₐᵣ), 7,08-6,98 (m, 12H, Hₐᵣ), 2,56 (t, 4H, J*=*7,6 Hz, CH₂), 1,57 (m, 4H, CH₂), 1,30 (m, 12H, CH₂), 0,87 (t, 6H, J*=*6,7 Hz, CH₃).* |
| *RMN ¹³C (CD2Cl2, 100 MHz):* | *δ* = 192,00 ; 156,15 ; 155,56 ; 154,05 ; 152,73 ; 147,85 ; 146,87 ; 143,54 ; 143,43 ; 142,03 ; 141,95 ; 141,49 ; 136,09 ; 131,59 ; 130,73 ; 130,00 ; 129,51 ; 129,25 ; 128,62 ; 128,36 ; 128,02 ; 124,60 ; 124,28 ; 123,32 ; 123,05 ; 122,14 ; 120,60 ; 63,59 ; 35,75 ; 32,03 ; 31,79 ; 29,40 ; 22,91 ; 14,16. |

### I.5. Acide 2-cyano-3-(4-(7-(6-(diphénylamino)-4,4-bis(4-hexylphényl)-4H-indéno[1,2-b]thiophèn-2-yl)benzo[c][1,2,5]thiadiazol-4-yl)phényl)acrylique [YKP88]

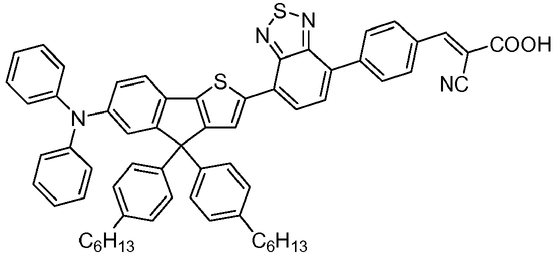

Sous atmosphère d'argon, du 4-(7-(6-(diphénylamino)-4,4-bis(4-hexylphényl)-4H-indéno[1,2-b]thiophèn-2-yl)benzo[c][1,2,5]thiadiazol-4-yl)benzaldéhyde [YKC4P87] (180 mg, 200 µmol) et de l'acide cyanoacétique (85 mg, 1 mmol, 5 eq) sont dissous dans un mélange d'acétonitrile (9 mL) et de chloroforme (9 mL). Une quantité catalytique de pipéridine est ajoutée et la solution est portée à reflux pendant 3 h. Le solvant est éliminé sous pression réduite et le solide restant est dissous dans le chloroforme. La phase organique est lavée avec une solution d'HCl (2 M), séchée sur du Na₂SO₄ et concentrée. Le solide brut est purifié par chromatographie sur gel de silice en utilisant, comme éluant, d'abord du DCM, puis du DCM/méthanol (MeOH) : 95/5 (v/v) et enfin du DCM/MeOH/Acide acétique : 90/5/5 (v/v) moyennant quoi le colorant correspondant est obtenu sous forme d'un solide rouge sombre (179,3 mg, 186 µmol, 92,7%).

| | |
|---|---|
| *RMN ¹H (THF-d₈, 400 MHz):* | *δ* = *8,33 (s, 1H, Hₐᵣ), 8,25 (ABq, 4H, Δvab=39,9 Hz, J*=*8,2 Hz, Hₐᵣ), 8,26 (s, 1H, Hₐᵣ), 8,05 (ABq, 4H, Δvab=51,4 Hz, J*=*7,5 Hz, Har), 7,44 (d, 1H, J*=*8,2 Hz, Hₐᵣ), 7,22-7,185 (m, 4H, Hₐᵣ), 7,14 (m, 3H, Hₐᵣ), 7,05-7,02 (m, 6H, Hₐᵣ), 6,99-6,95 (m, 2H, Hₐᵣ), 2,58 (t, 4H, J*=*7,6 Hz, CH₂), 1,57 (m, 4H, CH₂), 1,29 (m, 12H, CH₂), 0,87 (t, 6H, J*=*5,8 Hz, CH₃).* |
| *RMN ¹³C (THF-d₈, 100 MHz):* | *δ* = *164,18 ; 157,44 ; 156,82 ; 155,00 ; 154,36 ; 153,83 ; 149,08 ; 147,92 ; 144,78 ; 143,26 ; 142,85 ; 142,50 ; 132,98 ; 132,25 ; 131,33 ; 130,91 ; 130,40 ; 130,11 ; 129,43 ; 129,16 ; 125,66 ; 125,49 ; 124,25 ; 124,15 ; 123,50 ; 121,47 ; 116,74 ; 105,05 ; 64,73 ; 36,80 ; 33,12 ; 32,96 ; 31,05 ; 30,50 ; 23,90 ; 14,83.* |

### II. Synthèse du colorant DJ214.

### II.1. 5-(7-(6-(diphénylamino)-4,4-bis(4-hexylphényl)-4H-indéno[1,2-b]thiophèn-2-yl)benzo[c][1,2,5]thiadiazol-4-yl)furan-2-carbaldéhyde [DJ210]

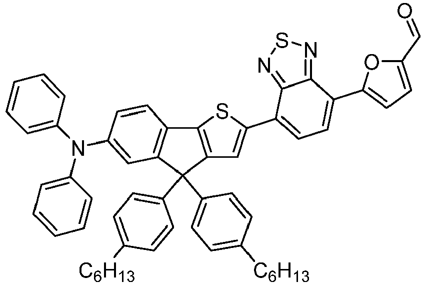

Sous atmosphère d'argon, du 4,4-dioctyl,N-N'-diphényl-4H-indéno[1,2-b]thiophèn-6-amine (650 mg, 0,98 mmol) est dissous dans du THF distillé (30 mL) puis du *n*-BuLi (0,43 mL, 1,01 mmol) est ajouté à -78°C. La solution est agitée pendant 1 h à -50°C avant d'ajouter une solution de Me₃SnCl (1,01 mL, 1,01 mmol) dans du *n*-hexane à -78°C. Après retour à température ambiante la solution est agitée pendant 2 h. La réaction est stoppée avec de l'eau et la phase organique est extraite avec du *n*-hexane, séchée sur du Na₂SO₄, filtrée et concentrée sous vide. L'huile résultante est soumise, sans autre purification, à un couplage de Stille avec du 4-bromo-7-(4-formylbenzyl)-2,1,3-benzothiadiazole (2433 mg, 0,78 mmol). Le produit stannique est mis, sous atmosphère d'argon avec du Pd₂dba₃ (18 mg, 20 µmol, 2%mol) et du P(*o*-tolyl)₃ (12 mg, 40 µmol). Les produits sont dissous dans du toluène anhydre (20 mL) et portés à reflux pendant 12 h. Le mélange est ensuite versé dans du HCl (2 M). La phase organique est extraite avec de l'éther diéthylique (EtzO), lavée avec du HCl (2 M), séchée sur du Na₂SO₄ et concentrée. Le solide brut est purifié par chromatographie sur gel de silice en utilisant, comme éluant, du cyclohexane/DCM : 6:4 (v/v) moyennant quoi un solide rouge est obtenu (490 mg, 0,55 mmol, 70,0%).

| | |
|---|---|
| *RMN ¹H (CDCl₃, 400 MHz):* | *δ* = *9,72 (s, 1H, CHO), 8,10 (s, 1H, Hₐᵣ), 8,08 (ABq, 2H, Δab*=*135,9 Hz, J*=*7,8Hz, Hₐᵣ), 7,65 (ABq, 2H, Δab*=*175,7 Hz, J*=*3,7 Hz, Hₐᵣ), 7,37 (d, 1H, J*=*8,2 Hz), 7,25-7,18 (m, 5H, Hₐᵣ), 7,10-7,05 (m, 4H, Hₐᵣ), 7,09 (ABq, 8H, Δab*=*42,0 Hz, J*=*8,4Hz), 7,02-6,96 (m, 3H, Hₐᵣ), 2,55 (t, 4H, J*=*7,3 Hz, CH₂), 1,63-1,53 (m, 4H, CH₂), 1,38-1,25 (m, 12H, CH₂), 0,87 (t, 6H, J*=*6,8 Hz, CH₃).* |
| *RMN ¹³C (CDCl₃, 100 MHz):* | *δ* = *177,25 ; 155,99 ; 155,45 ; 152,19 ; 151,80 ; 147,53 ; 146,60 ; 144,31 ; 141,62 ; 141,44 ; 140,76 ; 131,29 ; 129,19 ; 128,29 ; 127,84 ; 126,47 ; 124,64 ; 124,50 ; 124,30 ; 124,12 ; 123,92 ; 123,63 ; 122,97 ; 122,85 ; 121,98 ; 120,37 ; 119,11 ; 118,83 ; 113,88 ; 63,31 ; 35,54 ; 31,72 ; 31,38 ; 29,12 ; 22,60 ; 14,08.* |

### II.2. 2-cyano-3-(5-(7-(6-(diphénylamino)-4,4-bis(4-hexylphényl)-4H-indéno[1,2-b]thiophèn-2-yl)benzo[c][1,2,5]thiadiazol-4-yl)furan-2-yl)acrylic acid [DJ214]

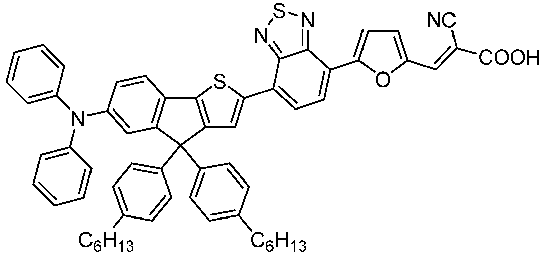

Sous atmosphère d'argon, du 5-(7-(6-(diphénylamino)-4,4-bis(4-hexylphényl)-4H-indéno[1,2-b]thiophèn-2-yl)benzo[c][1,2,5]thiadiazol-4-yl)furan-2-carbaldéhyde [DJ210] (470 mg, 0,52 mmol) et de l'acide cyanoacétique (225 mg, 2,65 mmol, 5 eq) sont dissous dans un mélange d'acétonitrile (60 mL) et de chloroforme (40 mL). Une quantité catalytique de pipéridine est ajoutée et la solution est portée à reflux pendant 3 h. Le solvant est éliminé sous pression réduite et le solide restant est dissous dans du chloroforme. La phase organique est lavée avec une solution d'HCl (2 M), séchée sur du Na₂SO₄ et concentrée. Le solide brut est purifié par chromatographie sur gel de silice en utilisant, comme éluant, d'abord du DCM, puis du DCM/MeOH : 95/5 (v/v) et enfin du DCM/MeOH/Acide acétique : 90/5/5 (v/v) moyennant quoi le colorant correspondant est obtenu sous forme d'un solide violet sombre (472 mg, 0,49 mmol, 93.0%).

| | |
|---|---|
| *RMN ¹H (THF-d₈, 400 MHz):* | *δ* = *8,40-8,20 (m large, 2H, Hₐᵣ), 7,09 (s large, 2H, Hₐᵣ), 7,90 (s large, 1H, Hₐᵣ),* 7,42 *(s large, 2H, Hₐᵣ), 7,30-7,15 (m, 9H, Hₐᵣ), 7,15-6,95 (m, 11H, Hₐᵣ), 2,58 (t, 4H, J*=*7,4 Hz, CH₂), 1,66-1,56 (m, 4H, CH₂), 1,43-1,27 (m, 12H, CH₂), 0,90 (t, 6H, J*=*6,7 Hz, CH₃).* |
| *RMN ¹³C (THF-d₈, 100 MHz):* | *δ* = *156,08 ; 155,47 ; 154,97 ; 151,85 ; 151,34 ; 148,57 ; 147,66 ; 146,61 ; 144,18 ; 141,87 ; 141,12 ; 136,76 ; 131,54 ; 129,02 ; 128,08 ; 127,81 ; 126,46 ; 124,39 ; 124,14 ; 122,82 ; 122,78 ; 122,02 ; 120,23 ; 118,87 ; 115,99 ; 114,74 ; 63,28 ; 35,40 ; 31,71 ; 31,55 ; 29,09 ; 22,49 ; 13,43.* |

### III. Synthèse du colorant YKP89.

### III.1. 4,4-bis(4-hexylphényl)-N,N-bis(4-méthoxyphényl)-4H-indéno[1,2-b]thiophèn-6-amine [YKC4P85]

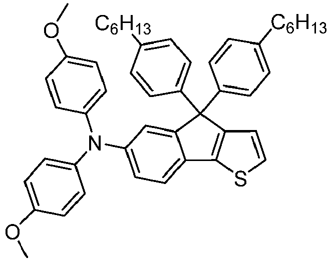

Sous atmosphère d'argon, du Pd₂dba₃ (3,20 mg, 3,50 µmol) et du tétrafluoroborate de tri-*tert*-butylphosphine (2,03 mg, 7,0 µmol) sont dissous dans du toluène anhydre (5 mL). Après agitation pendant 15 min, une solution de 6-bromo-4,4'-bis(4-hexylphényl)-4H-indéno[1,2-b]thiophène (200 mg, 349,9 µmol) et de 4,4'-diméthoxydiphénylamine (88,2 mg, 384,8 µmol) dans du toluène anhydre (10 mL) est ajoutée. Du *tert*-butoxyde de potassium (129,5 mg, 1,15 mmol, 3,3 eq) est ajouté et le mélange résultant est agité pendant 30 min à température ambiante, avant d'être porté à reflux pendant 48 h. Le mélange est ensuite filtré à travers de la célite et versé dans du HCl (2 M). La phase organique est extraite avec du DCM, lavée avec de l'eau, séchée sur du Na₂SO₄ et concentrée. L'huile brute est purifiée par chromatographie sur gel de silice en utilisant, comme éluant, du *n*-hexane/DCM : 9:1 (v/v) moyennant quoi une huile jaune pâle est obtenue (230 mg, 319,4 µmol, 91,3%).

| | |
|---|---|
| *RMN ¹H ((CD₃)₂CO, 400 MHz):* | *δ* = *7,41 (d, 1H, J*=*4,9 Hz, Hₐᵣ), 7,37 (d, 1H, J*=*8,2 Hz, Hₐᵣ), 7,12-7,06 (m, 10H, Hₐᵣ), 7,01 (m, 4H, Hₐᵣ), 6,88 (m, 4H, Hₐᵣ), 6,98 (m, 7H, Hₐᵣ), 6,81 (dd, 1H, J*=*2,1 Hz, J*=*8,2 Hz, Hₐᵣ), 3,80 (s, 6H, OCH₂), 2,58 (t, 4H, CH₂), 1,60 (m, 4H, CH₂), 1,33 (m, 12H, CH₂), 0,89 (t, 6H, CH₃).* |
| *RMN ¹³C ((CD₃)₂CO, 100 MHz):* | *δ* = *156,05 ; 154,99 ; 154,68 ; 146,99 ; 142,24 ; 141,16 ; 140,92 ; 129,99 ; 128,17 ; 127,66 ; 126,81 ; 126,13 ; 123,30 ; 119,54 ; 114,66 ; 62,74 ; 54,85 ; 35,17 ; 31,54 ; 31,36 ; 22,37 ; 13,45.* |

### III.2. 5-(7-(6-(bis(4-méthoxyphényl)amino)-4,4-bis(4-hexylphényl)-4H-indéno[1,2-b]thiophèn-2-yl)benzo[c][1,2,5]thiadiazol-4-yl)furan-2-carbaldéhyde [YKC4P86]

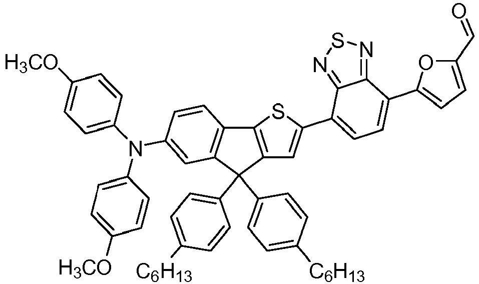

Sous atmosphère d'argon, de la 4,4-bis(4-hexylphényl)-N,N-bis(4-méthoxyphényl)-4H-indéno[1,2-b]thiophèn-6-amine [YKC4P85] (200 mg, 0,28 mmol) est dissoute dans du THF distillé (15 mL). Après avoir porté la solution à -78°C, du *n*-BuLi (213 µL, 319 µmol, 1,15 eq) est ajouté. La solution est agitée pendant 1 h à -78°C avant l'ajout d'une solution de Me₃SnCl (417 µL, 417 µmol, 1,5 eq) dans du n-hexane à -78°C. Après retour à température ambiante la solution est agitée pendant 2 h. La réaction est stoppée avec une solution saturée de chlorure d'ammonium. La phase organique est extraite avec du *n*-hexane, lavée avec de l'eau et séchée sur du Na₂SO₄, filtrée et concentrée sous vide. L'huile résultante est soumise, sans autre purification, à un couplage de Stille avec du 5-(7-bromobenzo[c][1,2,5]thiadiazol-4-yl)furan-2-carbaldéhyde (69 mg, 222 µmol, 0,8 eq). Le produit stannique est mis, sous atmosphère d'argon, avec du Pd₂dba₃ (5,1 mg, 5,56 µmol, 2%mol) et du P(*o*-tolyl)₃ (3,37 mg, 11,11 µmol, 4%mol). Les produits sont dissous dans du toluène anhydre (20 mL) et portés à reflux pendant 24 h. Le mélange est ensuite versé dans du HCl (2 M). La phase organique est extraite avec du DCM, lavée avec de l'eau, séchée sur du Na₂SO₄ et concentrée. Le solide brut est purifié par chromatographie sur gel de silice en utilisant, comme éluant, du DCM/*n*-hexane : 6:4 (v/v) moyennant quoi un solide violet foncé de type aldéhyde est obtenu (199 mg, 209 µmol, 94,4%).

| | |
|---|---|
| *RMN ¹H (CD₂Cl₂, 200 MHz):* | *δ* = *9,69 (s, 1H, CHO), 8,13 (s, 1H, Hₐᵣ), 8,07 (ABq, 2H, Δvab*=*58,4 Hz, J*=*8,1 Hz, Hₐᵣ), 7,64 (ABq, 2H, Δvab*=*84,0 Hz, J*=*3,5 Hz, Hₐᵣ), 7,32 (d, 2H, J*=*8,2 Hz, Hₐᵣ), 7,15-6,99 (m, 13H, Hₐᵣ), 6,80 (m, 5H, Hₐᵣ), 7,08-6,98 (m, 12H, Hₐᵣ), 3,78 (s, 6H, OCH₃), 2,56 (t, 4H, J*=*7,5 Hz, CH₂), 1,54 (m, 4H, CH₂), 1,30 (m, 12H, CH₂), 0,87 (t, 6H, J*=*6,7 Hz, CH₃).* |
| *RMN ¹³C (CD₂Cl₂, 50 MHz):* | *δ* = *177,74 ; 156,71 ; 155,86; 152,53 ; 148,43 ; 145,04 ; 142,49 ; 142,33 ; 141,28 ; 141,00 ; 129,80 ; 129,48 ; 128,96 ; 128,37 ; 127,12 ; 126,91 ; 124,97 ; 124,49 ; 120,93 ; 120,15 ; 119,74 ; 119,27 ; 115,23 ; 114,36 ; 63,84 ; 56,07 ; 36,12 ; 32,40 ; 32,20 ; 29,78 ; 23,28 ; 14,54.* |

### III.3. Acide 3-(5-(7-(6-(bis(4-méthoxyphényl)amino)-4,4-bis(4-hexylphényl)-4H-indéno[1,2-b]thiophèn-2-yl)benzo[c][1,2,5]thiadiazol-4-yl)furan-2-yl)-2-cyanoacrylique [YKP89]

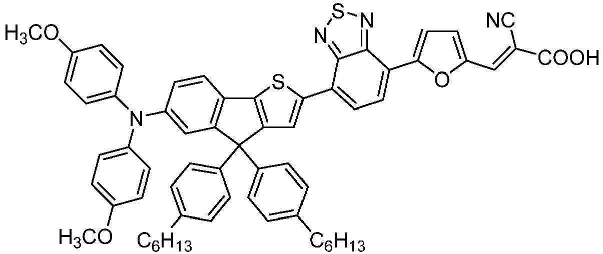

Sous atmosphère d'argon, du 5-(7-(6-(bis(4-méthoxyphényl)amino)-4,4-bis(4-hexylphényl)-4H-indéno[1,2-b]thiophèn-2-yl)benzo[c] [1,2,5]thiadiazol-4-yl)furan-2-carbaldéhyde [YKC4P86] (180 mg, 190 µmol) et de l'acide cyanoacétique (80 mg, 950 µmol, 5 eq) sont dissous dans un mélange d'acétonitrile (9 mL) et de chloroforme (9 mL). Une quantité catalytique de pipéridine est ajoutée et la solution est portée à reflux pendant 3 h. Le solvant est éliminé sous pression réduite et le solide restant est dissous dans du chloroforme. La phase organique est lavée avec une solution d'HCl (2 M), séchée sur du Na₂SO₄ et concentrée. Le solide brut est purifié par chromatographie sur gel de silice en utilisant, comme éluant, d'abord du DCM, puis du DCM/méthanol (MeOH) : 95/5 (v/v) et enfin du DCM/MeOH/Acide acétique : 90/5/5 (v/v) moyennant quoi le colorant correspondant est obtenu sous forme d'un solide violet foncé (179,3 mg, 177 µmol, 92,7%).

| | |
|---|---|
| *RMN ¹H (THF-d₈, 400 MHz):* | *δ* = *8,26 (s, 1H, Hₐᵣ), 8,25 (ABq, 2H, Δvab*=*88,7 Hz, J*=*7,7 Hz, Hₐᵣ), 8,04 (s, 1H, Hₐᵣ), 7,70 (ABq, 2H, Δvab*=*184,3 Hz, J*=*3,6 Hz, Har), 7,36 (d, 1H, J*=*8,3 Hz, Hₐᵣ), 7,13 (m, 3H, Har), 7,09 (d, 1H, J*=*2,1 Hz, Hₐᵣ), 7,04-6,97 (m, 7H, Hₐᵣ), 6,79 (m, 4H, Hₐᵣ), 3,75 (s, 6H, Hₐᵣ), 2,55 (t, 4H, J*=*7,9 Hz, CH₂), 1,57 (m, 4H, CH₂), 1,29 (m, 12H, CH₂), 0,87 (t, 6H, J*=*6,5 Hz, CH₃).* |
| *RMN ¹³C (THF-d₈, 100 MHz):* | *δ* = *190,60 ; 188,79 ; 175,94 ; 156,24 ; 155,35 ; 152,63 ; 152,37 ; 151,51 ; 148,49 ; 147,78 ; 142,11 ; 141,01 ; 140,73 ; 139,77 ; 139,71 ; 133,58 ; 128,00 ; 127,79 ; 126,19 ; 124,52 ; 124,29 ; 123,99 ; 120,00 ; 119,62 ; 118,99 ; 118,67; 114,67 ; 114,39 ; 63,22 ; 54,59 ; 35,43 ; 31,74 ; 31,60 ; 29,67 ; 29,14 ; 22,52 ; 13,45.* |

### IV. Synthèse du colorant YKP137.

### IV.1. N,N-bis(4-(hexyloxy)phényl)-4,4-bis(4-hexylphényl)-4H-indéno[1,2-b]thiophèn-6-amine [YKP131]

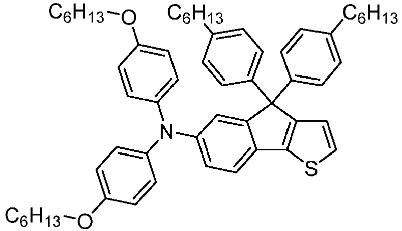

Sous atmosphère d'argon, du Pd₂dba₃ (6,40 mg, 7,0 µmol) et du tétrafluoroborate de tri-*tert*-butylphosphine (4,1 mg, 14,0 µmol) sont dissous dans du toluène anhydre (5 mL). Après agitation pendant 15 min, une solution de 6-bromo-4,4'-bis(4-hexylphényl)-4H-indéno[1,2-b]thiophène (400 mg, 699,7 µmol) et de di(hexyloxyphényl)amine (284,4 mg, 769,7 µmol, 1,1 eq) dans du toluène anhydre (10 mL) est ajoutée. Du *tert*-butoxyde de potassium (259,1 mg, 2,31 mmol, 3,3 eq) est ajouté et le mélange résultant est agité pendant 30 min à température ambiante, avant d'être porté à reflux pendant 48 h. Le mélange est ensuite filtré à travers de la célite et versé dans du HCl (2 M). La phase organique est extraite avec du DCM, lavée avec de l'eau, séchée sur du Na₂SO₄ et concentrée. L'huile brute est purifiée par chromatographie sur gel de silice en utilisant, comme éluant, du *n*-hexane/DCM : 9:1 (v/v) moyennant quoi une huile jaune pâle est obtenue (353 mg, 410 µmol, 58,7%).

| | |
|---|---|
| *RMN ¹H (CDCl₃, 400 MHz):* | *δ* = *7,42 (d, 1H, J*=*4,9 Hz, Hₐᵣ), 7,38 (d, 1H, J*=*8,2 Hz, Hₐᵣ), 7,13-7,07 (m, 10H, Hₐᵣ), 7,01 (m, 4H, Hₐᵣ), 6,88 (m, 4H, Hₐᵣ), 6,98 (m, 7H, Hₐᵣ), 6,82 (dd, 1H, J*=*2,1 Hz, J*=*8,2 Hz, Hₐᵣ), 4,00 (t, 4H, J*=*6,5 Hz, OCH₂), 2,59 (t, 4H, J*=*7,6 Hz, CH₂), 1,80 (m, 4H, CH₂), 1,62 (m, 4H, CH₂), 1,52 (m, 4H, CH₂), 1,36 (m, 20H, CH₂), 0,9 (dt, 12H, CH₃).* |
| *RMN ¹³C (CDCl₃, 100 MHz):* | *δ* = *157,02 ; 156,45 ; 156,13 ; 148,51 ; 143,73 ; 142,61 ; 142,27 ; 131,40 ; 129,63 ; 129,14 ; 128,23 ; 127,58 ; 124,77 ; 121,14 ; 121,10 ; 120,99 ; 116,72 ; 69,38 ; 64,20 ; 36,66 ; 33,03 ; 32,94 ; 32,85 ; 27,08 ; 23,88 ; 23,85 ; 14,90 ; 14,88.* |

### IV.2. 4-(7-(6-(bis(4-(hexyloxy)phényl)amino)-4,4-bis(4-hexylphényl)-4H-indéno[1,2-b]thiophèn-2-yl)benzo[c][1,2,5]thiadiazol-4-yl)benzaldéhyde [YKC4P134]

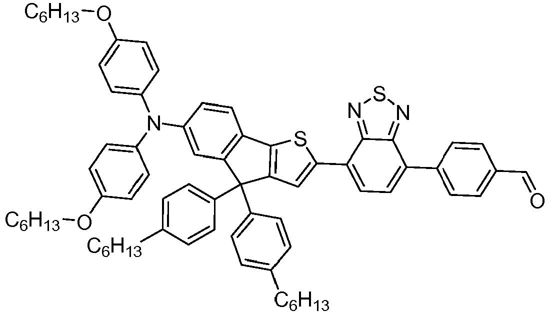

Sous atmosphère d'argon, de la N,N-bis(4-(hexyloxy)phényl)-4,4-bis(4-hexylphényl)-4H-indéno[1,2-b]thiophèn-6-amine [YKP131] (300 mg, 348,7 µmol) est dissoute dans du THF distillé (20 mL). Après avoir porté la solution à -78°C, du n-BuLi (287 µL, 401 µmol, 1,15 eq) est ajouté. La solution est agitée pendant 1 h à -78°C avant l'ajout d'une solution de Me₃SnCl (523 µL, 523 µmol, 1,5 eq) dans du n-hexane à -78°C. Après retour à température ambiante, la solution est agitée pendant 2 h. La réaction est stoppée avec une solution saturée de chlorure d'ammonium. La phase organique est extraite avec du n-hexane, lavée avec de l'eau et séchée sur du Na₂SO₄, filtrée et concentrée sous vide. L'huile résultante est soumise, sans autre purification, à un couplage de Stille avec du 4-bromo-7-(4-formylbenzyl)-2,1,3-benzothiadiazole (99 mg, 310,4 µmol, 0,89 eq). Le produit stannique est mis, sous atmosphère d'argon, avec du Pd₂dba₃ (6,4 mg, 7,0 µmol, 2%mol) et du P(*o*-tolyl)₃ (4,2 mg, 14,0 µmol, 4%mol). Les produits sont dissous dans du toluène anhydre (30 mL) et portés à reflux pendant 24 h. Le mélange est ensuite versé dans du HCl (2 M). La phase organique est extraite avec du DCM, lavée avec de l'eau, séchée sur du Na₂SO₄ et concentrée. Le solide brut est purifié par chromatographie sur gel de silice en utilisant, comme éluant, du DCM/n-hexane : 5:5 (v/v) moyennant quoi un solide violet de type aldéhyde est obtenu (275 mg, 250 µmol, 80,6%).

| | |
|---|---|
| *RMN ¹H (CD₂Cl₂, 400 MHz):* | *δ* = *10,17 (s, 1H, CHO), 8,32 (s, 1H, Hₐᵣ), 8,30 (d, 2H, J*=*8,3 Hz, Hₐᵣ), 8,10 (m, 3H, Hₐᵣ), 7,97 (d, 1H, J*=*7,6 Hz, Hₐᵣ), 7,48 (d, 1H, J*=*8,3 Hz, Hₐᵣ), 7,21-7,13 (m, 8H, Hₐᵣ), 7,09 (d, 1H, J*=*3,1 Hz, Hₐᵣ), 7,05 (m, 4H, Hₐᵣ), 6,90 (m, 4H, Hₐᵣ), 6,85 (dd, 1H, J*=*2,2 Hz, J*=*8,3 Hz, Hₐᵣ), 4,01 (t, 4H, J*=*6,5 Hz, OCH₂), 2,60 (t, 4H, J*=*7,8 Hz, CH₂), 1,80 (m, 4H, CH₂), 1,62 (m, 4H, CH₂), 1,52 (m, 4H, CH₂), 1,35 (m, 20H, CH₂), 0,9 (dt, 12H, CH₃).* |
| *RMN ¹³C (CD₂Cl₂, 100 MHz):* | *δ* = *192,59 ; 156,77 ; 156,14 ; 154,58 ; 153,20 ; 148,83 ; 144,68 ; 143,84 ; 142,97 ; 142,32 ; 141,47; 141,31 ; 137,05 ; 131,07 ; 131,05 ; 130,69 ; 130,45 ; 130,23 ; 130,17 ; 129,28 ; 128,75 ; 127,42 ; 125,31 ; 125,07 ; 121,20 ; 120,37 ; 119,83 ; 116,28 ; 68,89 ; 36,17 ; 32,52 ; 32,43 ; 32,35 ; 26,58 ; 23,38 ; 23,33 ; 14,41; 14,38.* |

### IV.3. Acide 3-(4-(7-(6-(bis(4-(hexyloxy)phényl)amino)-4,4-bis(4-hexylphényl)-4H-indéno[1,2-b]thiophèn-2-yl)benzo[c][1,2,5]thiadiazol-4-yl)phényl)-2-cyanoacrylique [YKP137]

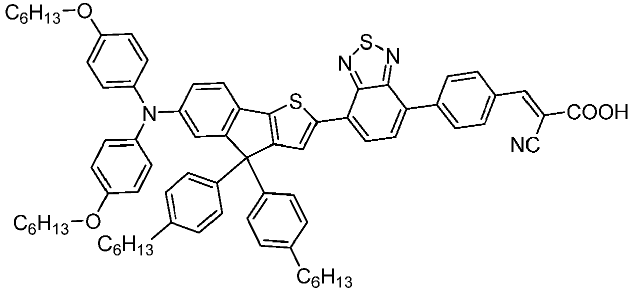

Sous atmosphère d'argon, du 4-(7-(6-(bis(4-(hexyloxy)phényl)amino)-4,4-bis(4-hexylphényl)-4H-indéno[1,2-b]thiophèn-2-yl)benzo[c][1,2,5]thiadiazol-4-yl)benzaldéhyde [YKC4P134] (275 mg, 250,3 µmol) et de l'acide cyanoacétique (213 mg, 2,5 mmol, 10 eq) sont dissous dans un mélange d'acétonitrile (20 mL) et de chloroforme (10 mL). Une quantité catalytique de pipéridine est ajoutée et la solution est portée à reflux pendant 3 h. Le solvant est éliminé sous pression réduite et le solide restant est dissous dans du chloroforme. La phase organique est lavée avec une solution d'HCl (2 M), séchée sur du Na₂SO₄ et concentrée. Le solide brut est purifié par chromatographie sur gel de silice en utilisant, comme éluant, d'abord du DCM, puis du DCM/MeOH : 95/5 (v/v) et enfin du DCM/MeOH/Acide acétique : 90/5/5 (v/v) moyennant quoi le colorant correspondant est obtenu sous forme d'un solide violet-bleu foncé (252,5 mg, 217 µmol, 86,5%).

| | |
|---|---|
| *RMN ¹H (THF-d₈, 400 MHz):* | *δ* = *8,32 (m, 3H, Hₐᵣ), 8,24 (s, 1H, Hₐᵣ), 8,22 (m, 2H, Hₐᵣ), 8,01 (ABq, 2H, Δvab*=*41,8 Hz, J*=*7,6 Hz, Hₐᵣ), 7,36 (d, 1H, J*=*8,3 Hz, Hₐᵣ), 7,13 (m, 4H, Hₐᵣ), 7,09 (d, 1H, J*=*2,1 Hz, Hₐᵣ), 7,03 (m, 4H, Hₐᵣ), 6,97 (m, 4H, Hₐᵣ), 6,81 (d, 1H, J*=*2,1 Hz, Hₐᵣ), 6,78 (m, 4H, Hₐᵣ), 3,92 (t, 4H, J*=*6,4 Hz, OCH₂), 2,55 (t, 4H, J*=*7,6 Hz, CH₂), 1,58 (m, 4H, CH₂), 1,49 (m, 4H, CH₂), 1,36-1,31 (m, 20H, CH₂), 0,90 (dt, 12H, CH₃).* |
| RMN ¹³C (THF-d₈, 100 MHz): | δ = 163,93 ; 156,64 ; 156,20 ; 154,50 ; 153,82 ; 153,33 ; 148,65 ; 144,82 ; 143,13 ; 142,40 ; 141,95 ; 141,61 ; 141,33 ; 132,44 ; 131,79 ; 130,41 ; 129,66 ; 128,95 ; 128,77 ; 127,09 ; 125,11 ; 124,89 ; 120,81 ; 120,59 ; 120,03 ; 115,88 ; 68,73 ; 64,22 ; 36,39 ; 32,70 ; 32,54 ; 30,33 ; 30,10 ; 26,75 ; 23,53 ; 23,47 ; 14,40. |

### V. Propriétés optiques des colorants selon l'invention.

Pour démontrer les avantages des colorants selon l'invention et notamment des colorants DJ214, YKP88, YKP89 et YKP137 dont la synthèse est décrite ci-dessus, nous avons utilisé, comme référence, deux colorants décrits dans la littérature que sont :
- le colorant RK1 correspondant à l'acide 2-cyano-3(4-(7-(5-(4-(diphényl amino)phényl)-4-octylthiophèn-2-yl)benzo[c][1,2,5] thiadiazol-4-yl)phényl)acrylique et de formule: 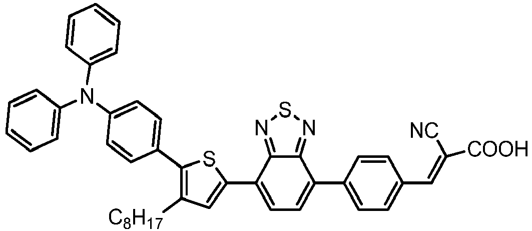
- le colorant RKF correspondant à l'acide 2-cyano-3-(4-(7-(6-(diphénylamino)-4,4-dihéxyl-4H-indeno[1,2-b]thiophèn-2-yl)benzo[c][1,2,5]thiadiazol-4-yl)phényl)acrylique et de formule:

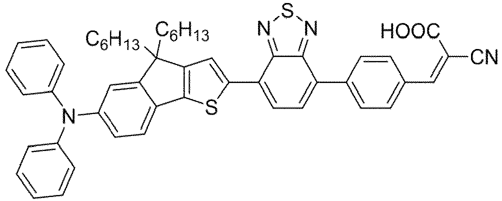

Il apparaît très clairement que les colorants selon l'invention présentent des spectres d'absorption améliorés par rapport à des colorants de l'état de l'art tels que RK1 ou RKF dont les rendements supérieurs à 9,5% en combinaison avec un électrolyte à base d'iode figurent parmi les plus élevés de la littérature.

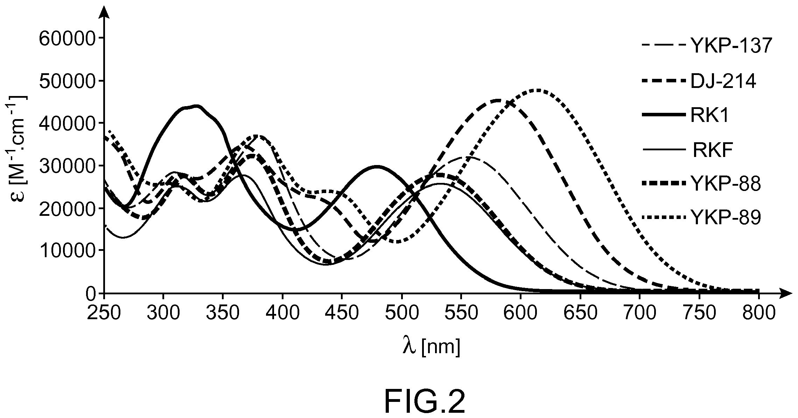

Les spectres des composés à savoir YKP137, DJ214, YKP88 et YKP89 de l'invention sont particulièrement bien adaptés pour des applications en cellules solaires car ils sont décalés dans le visible par rapport à RK1 ou RKF et/ou les coefficients d'absorption sont plus élevés (Figure 2).

De manière intéressante, les composés DJ214 et YKP89 révèlent des coefficients d'absorption molaires supérieurs à 40000 M⁻¹.cm⁻¹. Les coefficients d'absorption élevés permettent d'envisager des applications en configuration électrolyte liquide ionique et électrolyte solide. En effet, dans ces configurations, pour permettre une bonne pénétration dans l'électrode mésoporeuse de l'électrolyte visqueux, l'épaisseur des films mésoporeux doit rester faible notamment inférieure à 8 µm. Dans ce cas, la faible épaisseur est compensée par l'absorption forte du colorant.

### VI. Colorants selon l'invention et cellules à électrolyte liquide.

### VI.1. Matériel et méthodes

### A. Préparation des dispositifs à électrolyte liquide

Les films de TiOz ont été achetés à la société Solaronix, puis ils ont été traités par du TiCl4 et ensuite frittés à 500°C pendant 30 min. Après refroidissement, les électrodes ont été immergées dans une solution contenant les colorants en mélange avec l'acide déoxycholique (DCA) pendant 3 à 12 h à une température ambiante.

Pour la contre-électrode, les plaques en FTO (pour « Fluorine-doped Tin Oxide ») ont été alésées par un micro-foret, lavées avec une solution à 0,1 mol.L⁻¹ de HCl dans l'éthanol, puis ensuite lavées dans un bain soumis aux ultrasons avec de l'eau et de l'éthanol pendant 15 min. Une contre-électrode de platine a été préparée en coulant par gravité 5 mM de l'acide chloroplatinique (H₂PtCl₆) dans de l'alcool isopropylique sur les plaques en FTO lavées puis ensuite frittée à 400°C pendant 20 min sous air conditionné. Les électrodes ayant adsorbé le colorant ont été rinçées avec de l'éthanol et séchées sous flux d'azote. Les électrodes ayant adsorbé le colorant ont été assemblées et scellées avec la contre-électrode en utilisant des films adhésifs thermiques (Surlyn, Dupont 1702, épaisseur de 25 µm) en tant que cales polymères pour produire des cellules de type sandwich. L'électrolyte liquide est constitué de 0,7 mol.L⁻¹ d'iodure de 1-propyl-3-méthylimidazolium, de 0,03 mol.L⁻¹ d'iode, de 0,1 mol.L⁻¹ d'iodure de lithium et de 0,5 mol.L⁻¹ de tert-BP dans un mélange d'acétonitrile et de valéronitrile (85/15 v/v). Une solution électrolytique a été introduite via un trou foré sur la contre-électrode. Enfin, les trous ont été scellés avec des films thermofusibles et un couvre-objet. La surface typiquement active de la cellule était d'environ 0,36 cm².

### B. Mesures photovoltaïques et photoélectriques

Les mesures photovoltaïques des DSSC (pour « Dye Sensitized Solar Cells ») ont mis en oeuvre un simulateur solaire (AM 1.5 solar simulator) entre l'échantillon et une lampe excimère au xénon de 450 W. L'intensité de la lumière simulée a été calibrée par une cellule solaire de référence au Si équipée avec un filtre KG5 pour une irradiation globale d'environ AM 1.5. Les caractéristiques photovoltaïques des DSSC ont été obtenues en appliquant une polarisation de potentiel externe aux cellules et en mesurant le photo-courant généré avec un compteur de source Keithley modèle 2400. Le rendement de conversion photons incidents à courant incident (IPCE pour « Incident photon-to-current conversion efficiency ») a été mesuré comme une fonction de la longueur d'ondes de 300 nm à 800 nm en utilisant un système IPCE spécialement adapté pour les cellules solaires sensibilisées par un colorant. Une lampe à xénon de 75 W a été utilisée comme source de lumière pour générer un rayon monochromatique. La calibration a été réalisée en utilisant une photodiode de silicium calibrée au NIST (pour « National Institute of Standards and Technology ») comme standard. Les valeurs IPCE ont été collectées à une vitesse de hachage faible de 4 Hz. Les spectres d'impédance électrique ont été mesurés en utilisant un analyseur d'impédance (Solartron 1260) à un potentiel de circuit-ouvert sous une illumination plein soleil AM 1.5 (100 mW/cm²), avec une gamme de fréquences de 0,1~10⁵ Hz. L'amplitude du signal alternatif était de 10 mV. Les paramètres de l'impédance ont été déterminés en ajustant les spectres d'impédance en utilisant le logiciel Z-plot.

### VI.2. Résultats obtenus

### A. Rendements de conversion photovoltaïque avec électrolyte liquide

Afin de prouver que les colorants de l'invention présentant un spectre d'absorption amélioré permettent d'améliorer les rendements de conversion photovoltaïque, l'utilisation de ces colorants dans des cellules solaires sensibilisées a été réalisée en employant la structure de dispositif suivante :
- Sensibilisation avec les colorants d'une électrode de TiO₂ sur FTO.
- Sertissage avec cales polymères et contre-électrode et remplissage avec électrolyte liquide contenant le couple redox et, plus particulièrement, le couple redox I⁻ /I₃⁻.

Le Tableau 1 ci-après compile les résultats des cellules solaires contenant un électrolyte liquide à base d'iode.

Le fill factor (FF) est le facteur de remplissage ou encore facteur de qualité : il traduit la capacité de la cellule à évacuer efficacement les charges photogénérées, c'est le rapport entre la puissance maximum qui peut être obtenue avec une cellule sur la puissance réelle.

**Tableau 1**

| **Colorant 1 : CDCA 10** | **V_{oc} (mV)** | **J_{sc} (mA.cm⁻²)** | **FF (%)** | **η (%)** |
|---|---|---|---|---|
| **RK1** | 707 | 16,83 | 71 | 8,44 |
| **RKF** | 710 | 18,82 | 72 | 9,69 |
| **YKP88** | 706 | 18,96 | 71 | 9,54 |
| **YKP89** | 662 | 16,89 | 68 | 7,61 |
| **YKP137** | 729 | 18,56 | 70 | 9.38 |
| **DJ214** | 670 | 17,08 | 71 | 8,09 |
| *TiO₂ épaisseur 14 (T*/*SP) + 3 (R*/*SP) µm. Colorant dans CH₃CN*/*t-BuOH, 1:1 pendant 15 h.* | | | | |
| *Meilleur résultat pour 3 cellules de chaque colorant.* | | | | |

Il apparaît, de manière intéressante, que les composés de l'invention tous étudiés dans les mêmes conditions présentent, pour certains, des rendements de conversion supérieurs à la référence RK1. Grâce à leur spectre d'absorption plus décalé dans le domaine visible, ils collectent plus de photons et, par conséquent, ils permettent tous de générer plus de courant (Jsc) que la référence RK1.

Certains d'entre eux comme YKP88 avec des groupes phényles répondant à la structure chimique de l'invention présente des densités de courant plus élevées que son analogue RKF. De plus, ces composés absorbent dans des gammes de longueurs d'onde particulièrement recherchées pour les applications car rares.

De plus, la combinaison de plusieurs colorants pour sensibiliser les électrodes dont au moins un répond à la structure de l'invention permet d'améliorer significativement les rendements. Ceci est démontré par les résultats dans les Tableaux 2 et 3 ci-après.

**Tableau 2**

| **Colorant/CDCA, 1/10** | **V_{oc} (mV)** | **J_{sc} (mA.cm⁻²)** | **FF (%)** | **η (%) (meilleure cellule)** | **η (%) (moyenne 2 cellules)** |
|---|---|---|---|---|---|
| **RK1** | 724 | 14,54 | 72 | 7,65 | 7,63 |
| **RK1/YKP88, 1/1** | 730 | 15,50 | 71 | 8,10 | 7,96 |
| **YKP88** | 707 | 16,25 | 68 | 7,87 | 7,85 |
| *TiO₂épaisseur 8 (T*/*SP) + 4 (R*/*SP) µm. Colorant dans CH₃CN*/*t-BuOH, 1:1.* | | | | | |
| *Eluant avec 0,5 mM colorant + 5 mM CDCA pendant 3 h.* | | | | | |

**Tableau 3**

| **Colorant/CDCA, 1/10** | **V_{oc} (mV)** | **J_{sc} (mA.cm⁻²)** | **FF (%)** | **η (%) (1 cellule)** |
|---|---|---|---|---|
| **YKP88** | 733 | 17,29 | 73 | 9,23 |
| **YKP88/YKP137, 8/2** | 743 | 20,17 | 71 | 10,68 |
| **YKP137** | 718 | 19,23 | 69 | 9,57 |
| *TiO₂ épaisseur 14 (T*/*SP) + 3 (R*/*SP) µm. Colorant dans CH₃CN*/*t-BuOH, 1:1.* | | | | |
| *Eluant avec 0,5 mM colorant + 5 mM CDCA pendant 3 h.* | | | | |

De manière intéressante, lorsque deux composés issus de l'invention (Tableau 3) sont utilisés en combinaison, les rendements de conversion atteignent 10,68%. Cette performance figure parmi les 3 meilleures au niveau mondial en employant un électrolyte iodé.

### B. Rendements de conversion photovoltaïque avec électrolyte liquide ionique

Il est connu, dans l'état de l'art, que les cellules contenant des électrolytes liquides ont une propension à se dégrader rapidement, ce phénomène étant souvent lié à des problèmes de fuite et à l'évaporation du solvant.

Pour pallier à ces problèmes, une stratégie largement répandue consiste à utiliser un électrolyte à base de liquide ionique. En conséquence, l'utilisation des colorants de l'invention dans des cellules solaires sensibilisées a également été réalisée en employant la structure de dispositif suivante :
- Sensibilisation avec les colorants d'une électrode de TiO₂ sur FTO.
- Sertissage avec cales polymères et contre-électrode et remplissage avec un électrolyte liquide ionique contenant le couple redox et, plus particulièrement, le couple redox I⁻/I³⁻.

Le Tableau 4 ci-après compile les résultats des cellules solaires contenant un électrolyte liquide ionique à base d'iode.

**Tableau 4**

| **Colorant 1 : CDCA 10** | **V_{oc} (mV)** | **J_{sc} (mA.cm⁻²)** | **FF (%)** | **η (%)** |
|---|---|---|---|---|
| **RK1** | 651 | 13,81 | 71 | 6,38 |
| **RKF** | 670 | 17,50 | 67 | 7,87 |
| **YKP-88** | 642 | 17,39 | 66 | 7,36 |
| **YKP-89** | 585 | 16,98 | 66 | 6,60 |
| **YKP-137** | 665 | 14,09 | 60 | 5,65 |
| **DJ-214** | 609 | 16,51 | 68 | 6,80 |
| *TiO₂ épaisseur 8,5 (T*/*SP + MC*/*SP) + 3 (R*/*SP) µm. Colorant dans CH₃CN*/*t-BuOH, 1:1 pendant 15 h. Meilleur résultat pour 3 cellules de chaque colorant.* | | | | |

De manière très intéressante, tous les composés de l'invention à l'exception d'YKP137 présentent des rendements de conversion supérieurs à la référence RK1. Grâce à leur capacité améliorée de collecter les photons sur une plus large gamme de longueurs d'onde, tous les composés permettent de générer plus de courant lorsqu'ils sont utilisés en cellule.

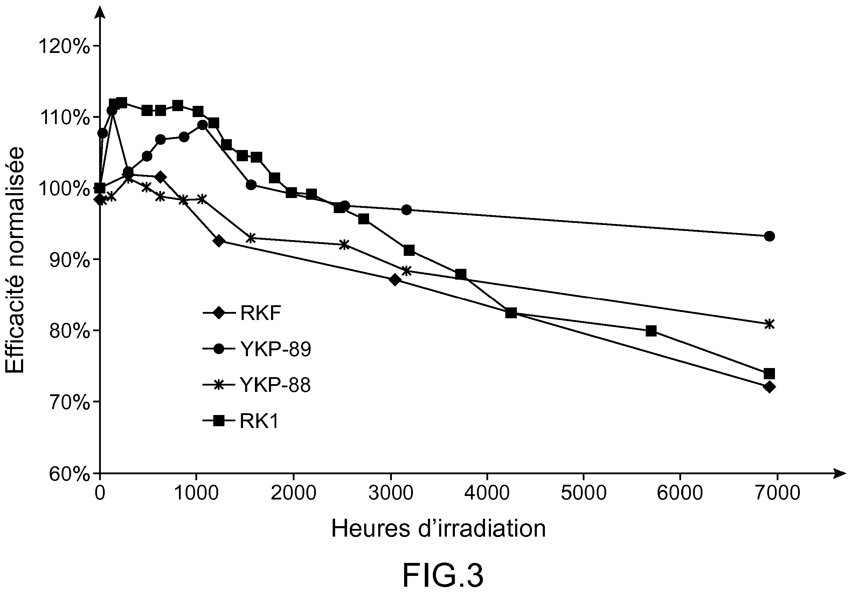

Le résultat le plus intéressant à signaler est que les dispositifs fabriqués avec les composés de l'invention présentent une stabilité fortement accrue (Figure 3). Ces stabilités ont été comparées à celle de RK1, seul composé à avoir été étudié dans ces conditions de dégradation accélérées (ISOS-L2) et qui présente une des meilleures résistances à la fatigue dans cette configuration de cellule jamais rapportée dans la littérature.

Ainsi, lorsque les cellules solaires réalisées avec un colorant selon la présente invention sont irradiées à 1000 W/m² à 65°C pendant 6900 h, elles conservent plus de 80% de leur efficacité initiale contre seulement 74% pour le colorant de référence RK1 qui fait partie des colorants les plus stables dans le domaine actuellement. La substitution des groupes alkyles (RKF) par des groupes aromatiques (son analogue YKP88) apporte clairement un effet bénéfique puisque YKP88 présente une bien meilleure stabilité par rapport à RKF (+9%). Le colorant YKP89 possède, quant à lui, la meilleure stabilité jamais enregistrée dans ces conditions pour un composé organique avec une perte de 7% d'efficacité en 7000 h.

### VII. Colorants selon l'invention et cellules à électrolyte solide.

Le fait que les colorants selon l'invention possèdent de forts coefficients d'absorption molaire est particulièrement intéressant pour le développement des cellules à électrolyte solide.

En effet, il est possible de remplacer un électrolyte liquide qui comporte de nombreux inconvénients en termes d'application (fuite, corrosion, évaporation) par un électrolyte de type solide conducteur de type p. C'est généralement le 2,2',7,7'-tetrakis(N,N-dip-méthoxyphény-amine)-9,9'-spirobifluorène ou Spiro-OMeTAD qui est classiquement employé comme conducteur de type p :

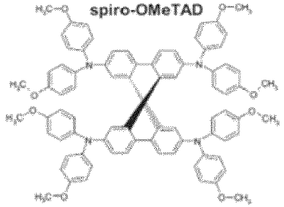

Dans le cas des dispositifs à électrolyte solide, un facteur limitant concerne la pénétration de l'électrolyte dans la couche d'oxyde mésoporeux. En effet, il est extrêmement difficile d'imprégner, par les électrolytes solides, des couches d'épaisseurs supérieures à 3 µm. Il est donc avantageux d'utiliser des colorants organiques à fort coefficient d'absorption pour permettre de diminuer l'épaisseur sans pour autant perdre en efficacité de collection de lumière.

### VII.1. Matériel et méthodes

Des dispositifs à électrolyte solide ont été réalisés avec des colorants selon l'invention et comparés à une molécule référence du domaine : le RK1.

La structure de cellule mise en oeuvre est la suivante : FTO/TiO₂ dense/TiOz mésoporeux (2 µm)/colorant/ Spiro-OMeTAD /Au (Surface Active: 0,15 cm²)

La procédure employée pour sa réalisation présente les principales étapes suivantes :
- dépôt de couches compactes de TiOz (250 nm) (bloqueuse de trous) par pyrolyse en spray sur substrats verre/FTO gravés ;
- dépôt de couches poreuses de TiO₂ à partir d'une colle commerciale de marque DYESOL et traitement thermique de calcination, épaisseur obtenue de 3 µm ;
- sensibilisation avec les colorants RK1, YKP88 ou YKP137, notamment entre 5 et 24 h avec 0,2 mM de colorant dans un mélange tert-butanol : acétonitrile (50:50 en volume) + 2mM d'acide chénodéoxycholique (CDCA) ;
- sensibilisation : 15 h dans le noir à température ambiante + rinçage à l'acétonitrile (ACN) ;
- remplissage des pores avec le verre moléculaire « spiro-OMeTAD » (Merck) avec spiro-OMeTAD à 200 mg/mL dans le chlorobenzène, dopé tert-BP et Li-TFSI ;
- dépôt d'une contre-électrode d'or (de quelques centaines de nanomètres) par évaporation sous vide (10⁻⁶ mbar).

### VII.2. Résultats obtenus

Des résultats préliminaires (non optimisés) obtenus en configuration électrolyte solide avec les colorants selon l'invention que sont YKP88 et YKP137 et la référence RK1 sont présentés dans le Tableau 5 ci-après.

**Tableau 5**

| **Colorant 1 : CDCA 10** | **V_{oc} (mV)** | **J_{sc} (mA.cm⁻²)** | **FF (%)** | **η (%)** |
|---|---|---|---|---|
| **RK1** | 772 | 9,17 | 58 | 4,11 |
| **YKP88** | 927 | 9,63 | 50 | 4,50 |
| **YKP137** | 815 | 10,25 | 47 | 3,90 |

Ces résultats démontrent encore une fois la supériorité des colorants de l'invention (YKP88 et YKP137) qui produisent, en cellules à électrolyte solide, plus de courant (supérieur à 9,5 mA/cm²) et conduisent à l'obtention de résultats équivalents ou meilleurs en terme de rendement de conversion au colorant de référence (RK1).

### BIBLIOGRAPHIE

**[1]** O'Regan et Grätzel, 1991, « A low-cost, high-efficiency solar cell based on dye-sensitized colloidal TiO2 films », Nature, vol. 353, pages 737-740.
**[2]** Grätzel, 2009, « Recent advances is mesoscopic solar cells », Acc. Chem. Res., vol. 42, pages 1781-1798.
**[3]** Mishra et al, 2009, « Metal-Free Organic Dyes for Dye-Sensitized Solar Cells: From Structure: Property Relationships to Design Rules », Angew. Chem. Int. Ed., vol. 48, pages 2474-2499.
**[4]** Yan et al, 2010, « Effect of surface etching on the efficiency of ZnO-based dye-sensitized solar cells », Langmuir, vol. 26, pages 7153-7156.
**[5]** Idigoras et al, 2015, « Organic dyes for the sensitization of nanostructured ZnO photoanodes: effect of the anchoring functions », RSC Adv., vol. 5, pages 68929-68938.
**[6]** Ooyama et Harima, 2009, « Molecular designs and synthèses of organic dyes for dye-sensitized solar cells », Eur. J. Org. Chem., vol. 2009, pages 2903-2934.
**[7]** Wang et al., 2005, « A high molar extinction coefficient sensitizer for stable dye-sensitized solar cells », J. Am. Chem. Soc., vol. 127, pages 808-809.
**[8]** Demande internationale WO 2009/109499 au nom de BASF SE et publiée le 11 septembre 2009.
**[9]** Chen et al., 2007, « Effect of tetrahydroquinoline dyes structure on the performance of organic dye-sensitized solar cells », Chem. Mater., vol. 19, pages 4007-4015.
**[10]** Wu et al, 2010, « Efficient and stable dye-sensitized solar cells based on phenothiazine sensitizers with thiophene units », J. Mater. Chem., vol. 20, pages 1772-1779.
**[11]** Xu et al, 2008, « New triphenylamine-based dyes for dye-sensitivized solar cells », J. Phys. Chem. C, vol. 112, pages 874-880.
**[12]** Liu et al, 2008, « Simple organic molécules bearing a 3,4-ethyledioxythiophene linker for efficient dye-sensitivized solar cells », Chem. Commun., vol. 2008, pages 5152-5154.
**[13]** Zeng et al, 2010, « Efficient dye-sensitivized solar cells with an organic photosensitizer featuring orderly conjugated ethylenedioxythiophene and dithienosilole blocks », Chem. Mater., vol. 22, pages 1915-1925.
**[14]** Mathew et al, 2014, « Dye-sensitized solar cells with 13% efficiency achieved through the molecular engineering of porphyrin sensitizers », Nat. Chem., vol. 6, pages 242-247.
**[15]** Joly et al, 2014, « A robust organic dye for dye sensitized solar cells based on iodine/iodide electrolytes combining high efficiency and outstanding stability », Sci. Rep., vol. 4, 4033.
**[16]** Demande internationale WO 2013/068588 au nom du CEA et publiée le 16 mai 2013.
**[17]** Joly et al, 2015, « Metal-free organic sensitizer with narrow absorption in the visible for solar cells exceeding 10% efficiency », Energy Environ. Sci., vol. 8, pages 2010-2018.
**[18]** Kalyanasundaram K., 2010, « Dye Sensitized Solar Cells », (ed.), EPFL Press, ISBN: 978-2-940222-36-0 CRC Press ISBN 978-1-4398-0866-5.

## Revendications

1. Colorant organique répondant à l'une des structures (I) ou (II) suivantes :
eD-chromophore pi-conjugué-L-A (I)
A-L-chromophore pi-conjugué-eD (II)
avec
- eD représente un segment électro-donneur,
- L représente une liaison covalente ou un segment espaceur, ledit segment espaceur étant une chaîne alcénylène ou alcynylène éventuellement substituée et/ou une chaîne arylène éventuellement substituée,
- A représente un segment électro-attracteur apte à former une liaison covalente avec un semi-conducteur,
dans lequel le chromophore pi-conjugué comprend au moins un motif de formule (III) : 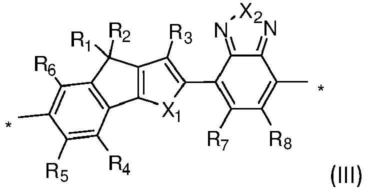 dans laquelle
- les radicaux R₁ et R₂, identiques ou différents, représentent un groupement aryle éventuellement substitué ;
- les radicaux R₃ à R₈, identiques ou différents, représentent un hydrogène, un groupement alkyle éventuellement substitué ou un groupement aryle éventuellement substitué ; et
- X₁ et X₂, identiques ou différents sont choisis parmi S, Se et O,
un segment électro-donneur (eD) étant un groupement amino de type (Z₁)(Z₂)N-, avec Z₁ et Z₂, identiques ou différents, représentant un groupement alkyle éventuellement substitué ou un groupement aryle éventuellement substitué et
un segment électro-accepteur (A) étant un groupement acide carboxylique, un groupement acide cyanoacrylique, un groupement phosphonique, un groupement dithiocarboïque ou un groupement répondant à l'une quelconque des formules ci-après :

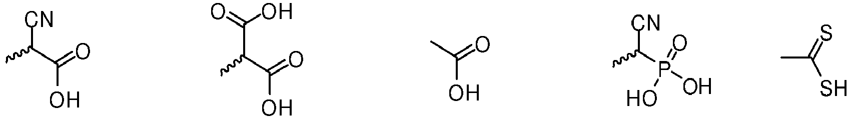

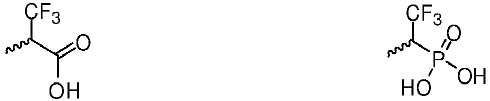

2. Colorant organique selon la revendication 1, **caractérisé en ce que** ledit couple (X₁,X₂) représente (S,S), (O,O) ou (Se,Se) et, en particulier, (S,S).

3. Colorant organique selon la revendication 1 ou 2, **caractérisé en ce que**, dans ledit motif (III), lesdits radicaux R₄ à R₆ sont identiques et/ou les radicaux R₇ et R₈ sont identiques, lesdits radicaux R₄ à R₆ représentant, de préférence, tous un hydrogène et/ou les radicaux R₇ et R₈ représentant, de préférence, tous un hydrogène.

4. Colorant organique selon l'une quelconque des revendications 1 à 3, **caractérisé en ce que**, dans ledit motif (III), ledit radical R₃ représente un hydrogène.

5. Colorant organique selon l'une quelconque des revendications 1 à 4, **caractérisé en ce que**, dans ledit motif (III), lesdits radicaux R₁ et R₂ sont identiques et représentent un groupement aryle éventuellement substitué et notamment un groupement aryle substitué par un groupement alkyle éventuellement substitué.

6. Colorant organique selon l'une quelconque des revendications 1 à 5, **caractérisé en ce que** ledit motif (III) est de formule (IV) : 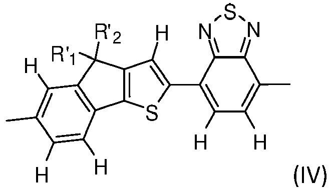 dans laquelle les radicaux R'₁ et R'₂ sont identiques et représentent -C₆H₄-C₆H₁₃.

7. Colorant organique selon l'une quelconque des revendications 1 à 6, **caractérisé en ce que** ledit colorant organique est choisi parmi les composés suivants :

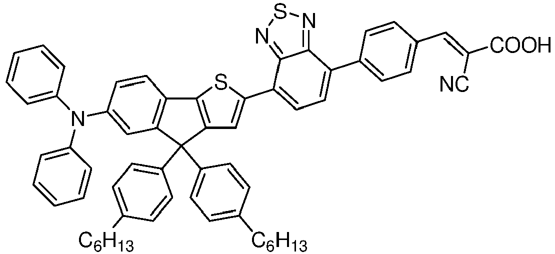

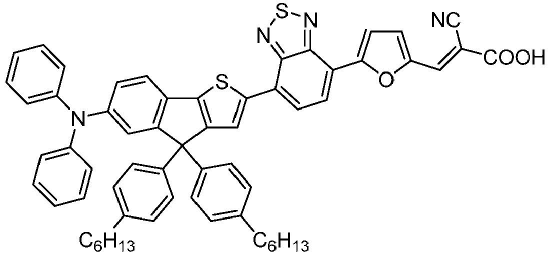

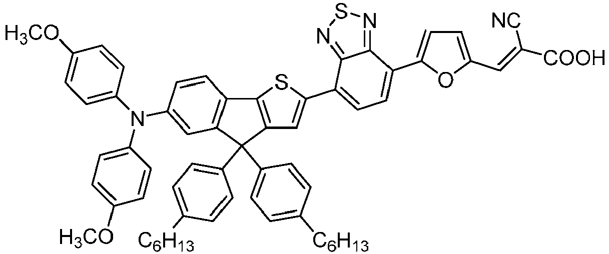

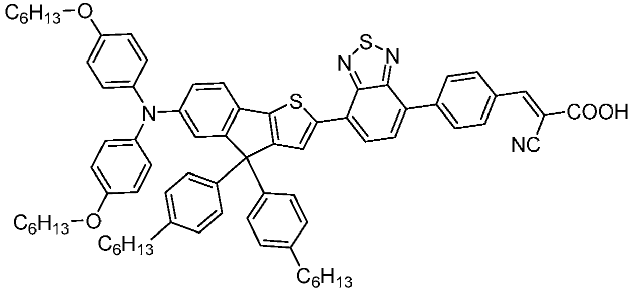

8. Utilisation d'un colorant organique tel que défini dans l'une quelconque des revendications 1 à 7, comme photosensibilisateur dans un dispositif photovoltaïque.

9. Dispositif photovoltaïque présentant une couche d'oxyde métallique semi-conducteur nanostructuré sensibilisée par au moins un colorant organique tel que défini dans l'une quelconque des revendications 1 à 7.

10. Dispositif photovoltaïque selon la revendication 9, **caractérisé en ce que** ledit dispositif photovoltaïque comprend en outre deux électrodes, dénommées, dans le cadre de l'invention, anode et contre électrode, et séparées l'une de l'autre par un électrolyte et éventuellement des cales polymères.

11. Dispositif photovoltaïque selon la revendication 9 ou 10, **caractérisé en ce que** ledit oxyde métallique semi-conducteur est un oxyde métallique binaire, tertiaire ou quaternaire.

12. Dispositif photovoltaïque selon l'une quelconque des revendications 9 à 11, **caractérisé en ce que** ledit électrolyte est un liquide, un liquide ionique, un gel ou un solide.

## Patentansprüche

1. Organischer Farbstoff, der eine der folgenden Strukturen (I) oder (II) aufweist:
eD - pi-konjugierter Chromophor - L - A (I)
A - L - pi-konjugierter Chromophor - eD (II)
wobei
- eD ein Segment für Elektrospender darstellt,
- L eine kovalente Bindung oder ein Spacersegment darstellt, wobei das Spacersegment eine optional substituierte Alkenylen- oder Alkinylenkette und/oder eine optional substituierte Arylenkette ist,
- A ein elektroziehendes Segment darstellt, das in der Lage ist, eine kovalente Verbindung mit einem Halbleiter einzugehen,
wobei der pi-konjugierte Chromophor mindestens eine Einheit der Formel (III) umfasst: 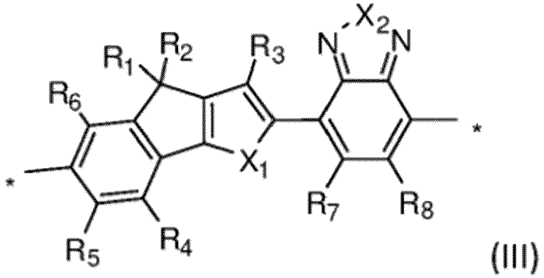 wobei
- die Reste R₁ und R₂, gleich oder unterschiedlich, eine optional substituierte Arylgruppe darstellen;
- die Reste R₃ bis R₈, gleich oder unterschiedlich, Wasserstoff, eine optional substituierte Alkylgruppe oder eine optional substituierte Arylgruppe darstellen; und
- X₁ und X₂, identisch oder unterschiedlich, ausgewählt aus S, Se und O sind,
ein Elektronendonorsegment (eD), bei dem es sich um eine Aminogruppe vom Typ (Z₁)(Z₂)N- handelt, wobei Z₁ und Z₂, die gleich oder unterschiedlich sein können, eine gegebenenfalls substituierte Alkylgruppe oder eine gegebenenfalls substituierte Arylgruppe darstellen, und ein Elektronenakzeptorsegment (A), bei dem es sich um eine Carbonsäuregruppe, eine Cyanoacrylsäuregruppe, eine Phosphongruppe, eine Dithiocarbonsäuregruppe oder eine Gruppe entsprechend einer der nachstehenden Formeln handelt:

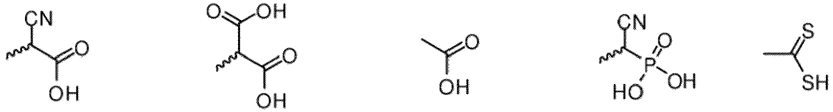

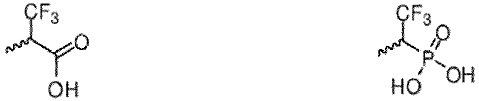

2. Organischer Farbstoff nach Anspruch 1, **dadurch gekennzeichnet, dass** das Paar (X₁, X₂) (S, S), (O, O) oder (Se, Se) und insbesondere (S, S) darstellt.

3. Organischer Farbstoff nach Anspruch 1 oder 2, **dadurch gekennzeichnet, dass** in der Einheit (III) die Reste R₄ bis R₆ identisch sind und/oder die Reste R₇ und R₈ identisch sind, wobei die Reste R₄ bis R₆ vorzugsweise alle Wasserstoff darstellen und/oder die Reste R₇ und R₈ vorzugsweise alle Wasserstoff darstellen.

4. Organischer Farbstoff nach einem der Ansprüche 1 bis 3, **dadurch gekennzeichnet, dass** in der Einheit (III) der Rest R₃ ein Wasserstoff darstellt.

5. Organischer Farbstoff nach einem der Ansprüche 1 bis 4, **dadurch gekennzeichnet, dass** in der Einheit (III) die Reste R₁ und R₂ identisch sind und eine gegebenenfalls substituierte Arylgruppe und insbesondere eine durch eine gegebenenfalls substituierte Alkylgruppe substituierte Arylgruppe darstellen.

6. Organischer Farbstoff nach einem der Ansprüche 1 bis 5, **dadurch gekennzeichnet, dass** die Einheit (III) die Formel (IV) aufweist: 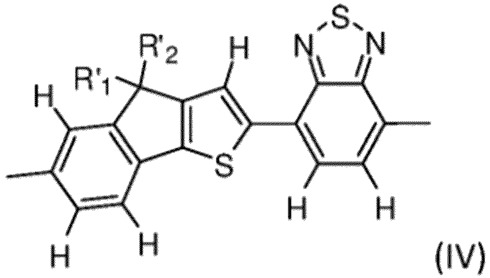 in denen die Reste R'₁ und R'₂ identisch sind und -C₆H₄-C₆H₁₃ darstellen.

7. Organischer Farbstoff nach einem der Ansprüche 1 bis 6, **dadurch gekennzeichnet, dass** der organische Farbstoff aus den folgenden Verbindungen ausgewählt ist:

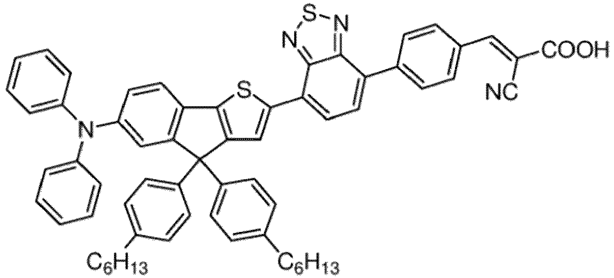

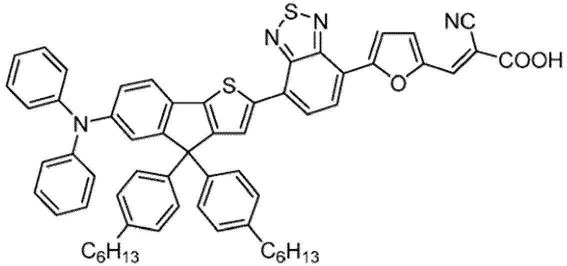

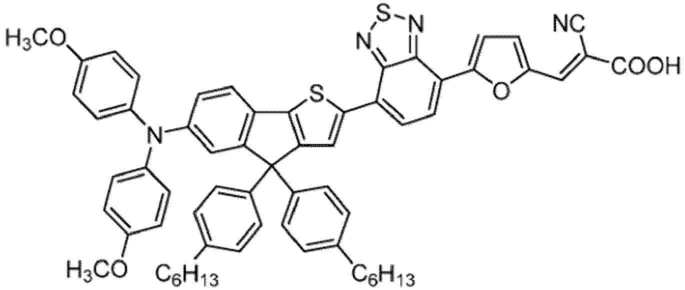

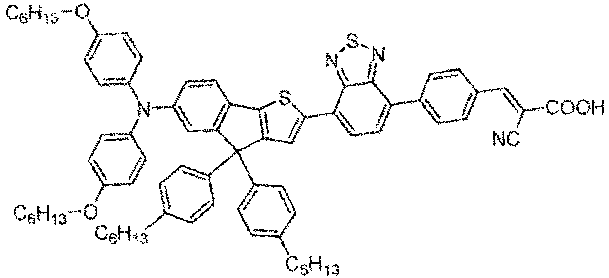

8. Verwendung eines organischen Farbstoffs nach wie einem der Ansprüche 1 bis 7 als Photosensibilisator in einer photovoltaischen Vorrichtung.

9. Photovoltaische Vorrichtung, die eine nanostrukturierte Halbleitermetalloxidschicht aufweist, die durch mindestens einen organischen Farbstoff nach einem der Ansprüche 1 bis 7 sensibilisiert ist.

10. Photovoltaische Vorrichtung nach Anspruch 9, **dadurch gekennzeichnet, dass** die photovoltaische Vorrichtung ferner zwei Elektroden umfasst, die im Rahmen der Erfindung Anode und Gegenelektrode genannt werden und durch einen Elektrolyten und optional polymere Abstandshalter voneinander getrennt sind.

11. Photovoltaische Vorrichtung nach Anspruch 9 oder 10, **dadurch gekennzeichnet, dass** das Halbleitermetalloxid ein binäres, tertiäres oder quaternäres Metalloxid ist.

12. Photovoltaische Vorrichtung nach einem der Ansprüche 9 bis 11, **dadurch gekennzeichnet, dass** der Elektrolyt eine Flüssigkeit, eine ionische Flüssigkeit, ein Gel oder ein Feststoff ist.

## Claims

1. An organic dye corresponding to one of the following structures (I) or (II):
eD - pi-conjugated chromophore - L - A (I)
A - L- pi-conjugated chromophore - eD (II)
with
- eD represents an electron-donor segment;
- L represents a covalent bond or a spacer segment, said spacer segment being an optionally substituted alkenylene or alkynylene chain and/or an optionally substituted arylene chain,
- A represents an electron-attractor segment capable of forming a covalent bond with a semi-conductor;
wherein the pi-conjugated chromophore comprises at least one unit of formula (III): 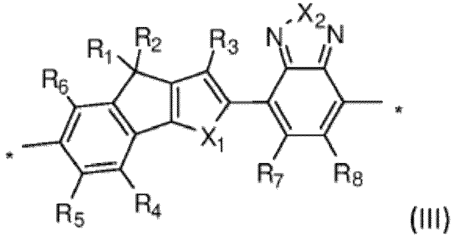 wherein
- the radicals R₁ and R₂, identical or different, represent an optionally substituted aryl group;
- the radicals R₃ to R₈, identical or different, represent a hydrogen, an optionally substituted alkyl group or an optionally substituted aryl group; and
- X₁ and X₂, identical or different, are selected from S, Se and O,
an electron-donor segment (eD) being an amino group of the (Z₁)(Z₂)N- type with Z₁ and Z₂, identical or different, representing an optionally substituted alkyl group or an optionally substituted aryl group and
an electron-acceptor segment (A) being a carboxylic acid group, a cyanoacrylic acid group, a phosphonic group, a dithiocarboic group or a group corresponding to any of the formulas below:

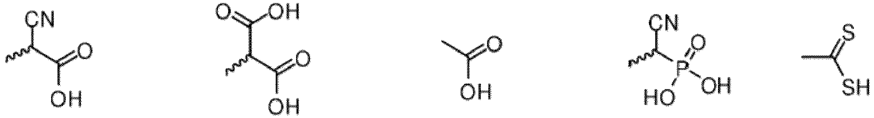

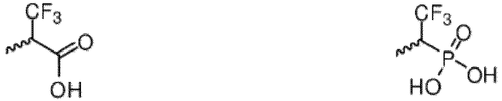

2. The organic dye according to claim 1, **characterised in that** said couple (X₁,X₂) represents (S,S), (O,O) or (Se,Se) and, in particular, (S,S).

3. The organic dye according to claim 1 or 2, **characterised in that**, in said unit (III), said radicals R₄ to R₆ are identical and/or the radicals R₇ and R₈ are identical, said radicals R₄ to R₆ preferably all representing hydrogen and/or the radicals R₇ and R₈ preferably all representing hydrogen.

4. The organic dye according to any one of claims 1 to 3, **characterised in that**, in said unit (III), said radical R₃ represents hydrogen.

5. The organic dye according to any one of claims 1 to 4, **characterised in that**, in said unit (III), said radicals R₁ and R₂ are identical and represent an optionally substituted aryl group and in particular an aryl group substituted by an optionally substituted alkyl group.

6. The organic dye according to any one of claims 1 to 5, **characterised in that** said unit (III) is of formula (IV): 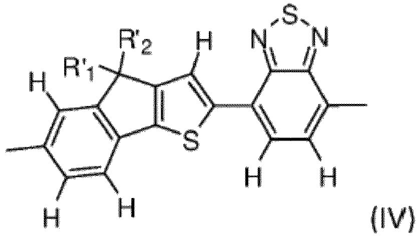 wherein the radicals R'₁ and R'₂ are identical and represent -C₆H₄-C₆H₁₃.

7. The organic dye according to any one of claims 1 to 6, **characterised in that** said organic dye is selected from the following compounds:

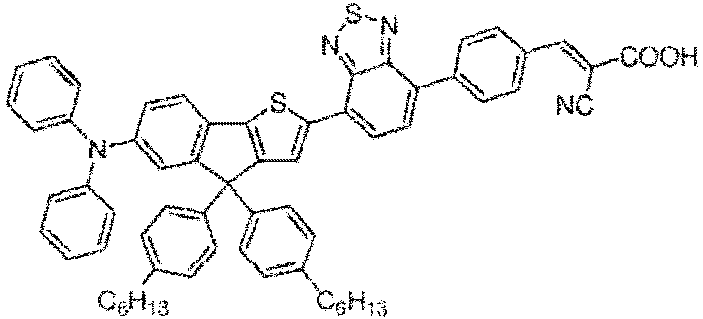

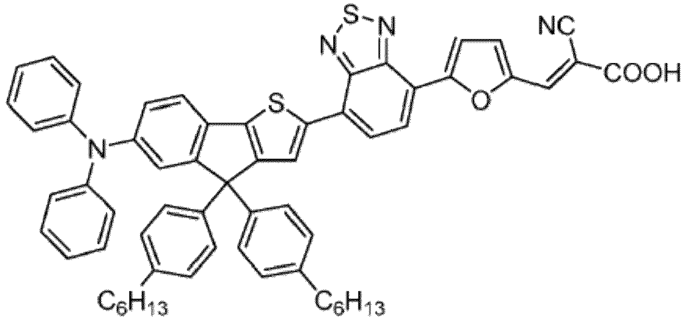

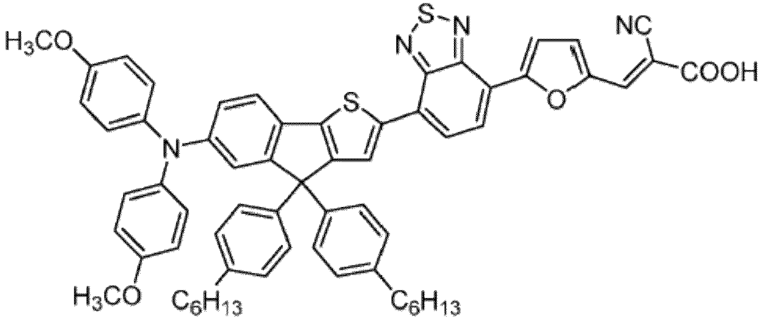

8. A use of an organic dye as defined in any one of claims 1 to 7, as a photosensitiser in a photovoltaic device.

9. A photovoltaic device having a nanostructured semiconductor metal oxide layer sensitised by at least one organic dye as defined in any one of claims 1 to 7.

10. The photovoltaic device according to claim 9, **characterised in that** said photovoltaic device further comprises two electrodes, called, within the scope of the invention, anode and counter electrode, and separated from each other by an electrolyte and optionally polymer shims.

11. The photovoltaic device according to claim 9 or 10, **characterised in that** said semiconductor metal oxide is a binary, tertiary or quaternary metal oxide.

12. The photovoltaic device according to any one of claims 9 to 11, **characterised in that** said electrolyte is a liquid, an ionic liquid, a gel or a solid.
